(19) Europäisches Patentamt

European Patent Office

Office européen des brevets

(11) **EP 1 662 553 A1**

(12) **EUROPEAN PATENT APPLICATION**
published in accordance with Art. 158(3) EPC

(43) Date of publication:
**31.05.2006 Bulletin 2006/22**

(51) Int Cl.:
*H01L 21/027* (1990.01)   *G02B 27/28* (1968.09)
*G02B 19/00* (1968.09)

(21) Application number: **04746597.6**

(22) Date of filing: **29.06.2004**

(86) International application number:
**PCT/JP2004/009128**

(87) International publication number:
**WO 2005/010963 (03.02.2005 Gazette 2005/05)**

(84) Designated Contracting States:
**AT BE BG CH CY CZ DE DK EE ES FI FR GB GR
HU IE IT LI LU MC NL PL PT RO SE SI SK TR**

(30) Priority: **24.07.2003 JP 2003201079
29.09.2003 JP 2003338446**

(71) Applicant: **NIKON CORPORATION
Tokyo 100-8331 (JP)**

(72) Inventors:
• **Muramatsu, Kenichi,**
c/o Nikon Corporation
Tokyo 100-8331 (JP)

• **Komine, Norio,**
c/o Nikon Corporation
Tokyo 100-8331 (JP)
• **Tanitsu, Osamu,**
c/o Nikon Corporation
Tokyo 100-8331 (JP)
• **Tanaka, Hirohisa,**
c/o Nikon Corporation
Tokyo 100-8331 (JP)

(74) Representative: **Viering, Jentschura & Partner
Steinsdorfstrasse 6
80538 München (DE)**

(54) **ILLUMINATING OPTICAL SYSTEM, EXPOSURE SYSTEM AND EXPOSURE METHOD**

(57)    An illuminating optical system capable of preventing a change in the polarized status of a linearly polarized light passing through a light transmitting member formed of a cubic-system crystal material such as fluorite. An illuminating optical system comprising a light source unit (1) for supplying a linearly polarized light to illuminate surfaces (M, W) to be illuminated with a light from the light source unit. The system is provided with a polarized status switching means (10, 20) disposed on a light path between the light source unit and the surfaces to be illuminated, for switching the polarized status of a light, that illuminates the surfaces to be illuminated, between a linearly polarized status and a nonlinearly polarized status. The polarized status switching means has a phase member (10) for changing the polarization surface of an incident linearly polarized light as needed, and a depolarizer (20) for depolarizing an incident linearly polarized light as needed. A phase advancing axis direction in association with the double refraction variation of a light transmitting member formed of fluorite is so set as to almost agree with or cross almost perpendicularly to the field vibration direction of a linearly polarized light incident to a light transmitting member.

[Figure 1]

## Description

Technical field

The present invention relates to illumination optical equipment, exposure equipment and an exposure method, and in particular relates to exposure equipment for manufacturing microdevices such as semiconductor elements, image pickup elements, liquid crystal display elements or thin film magnetic heads in a lithographic step.

Background art

In typical exposure equipment of this type, the optical flux that is emitted from the light source forms a secondary light source constituting a substantially planar light source comprising a large number of light sources, that are integrated by means of an optical integrator constituted by a fly-eye lens. The optical flux from this secondary light source is restricted by means of an aperture stop that is arranged in the vicinity of the downstream side focal plane of the fly-eye lens, before being input to a condenser lens.

The optical flux that is focussed by this condenser lens illuminates in superimposed fashion a mask that is formed with a prescribed pattern. After passing through the pattern of the mask, the light is imaged on a wafer, by means of a projection optical system. In this way, the mask pattern is exposed by projection (i.e. transferred) onto the wafer. It should be noted that the pattern that is formed on the mask has a high density of integration and so it is indispensable to obtain a uniform illumination distribution on the wafer in order to accurately transfer this fine pattern onto the wafer.

Techniques have therefore attracted attention wherein a secondary light source of circular shape is formed on the downstream-side focal plane of the fly-eye lens, and the coherency σ (σ value= the aperture stop diameter/the pupil diameter of projection optical system, or σ value=emission side numerical aperture of the illumination optical system/ input side numerical aperture of the projection optical system) of illumination can be varied by varying the size thereof. Techniques have also attracted attention wherein an annular shaped or quadrupole-shaped secondary light source is formed on the downstream side focal plane of the fly-eye lens, in order to improve depth of focus and/or resolution of the projection optical system.

Disclosure of the invention

Problem that the invention is intended to solve

With conventional exposure equipment as described above, in accordance with the characteristics of the pattern of the mask, ordinary circular illumination was performed using a secondary light source of circular shape, or modified illumination (annular illumination or quadrupole illumination) was performed using a secondary light source of annular shape or quadrupole shape. However, it was not possible to change the condition of polarization of the light illuminating the mask in accordance with the pattern characteristics of the mask, so, usually, the mask was illuminated with light in a non-polarized condition and appropriate illumination conditions required for faithfully transferring the mask pattern could not necessarily be achieved.

Also, if for example an ArF excimer laser light source was employed as the light source, typically the required durability was secured by employing fluorite for optically transparent members that are subjected to illumination by light of high energy density. As will be described, the present inventors discovered that fluorite has the property of varying the condition of polarization of emitted light on being subjected to illumination by laser light. When incoming linearly polarized light is changed to elliptically polarized light by passing through an optical transparent member formed by fluorite, not only does the quartz prism cease to function as a non-polarizing element, but also the variation of the polarization condition changes the actual ratio of the polarization components of the light incident on the sensor, making it difficult to precisely control the amount of light.

The present invention was made in the light of the problem described above. An object of the present invention is to provide an optical system and illumination optical equipment capable of suppressing changes in polarization condition of linearly polarized light passing through an optically transparent member formed by crystalline material of the cubic system, such as fluorite. Also, an object of the present invention is to provide exposure equipment and an exposure method whereby excellent exposure can be effected under appropriate illumination conditions realized in accordance with the pattern characteristics of the mask, using illumination optical equipment capable of suppressing changes in the polarization condition of linearly polarized light.

Means for solving the problem

In order to solve the above problem, according to a first aspect of the present invention, in an optical system including an optically transparent member formed of crystalline material, there is provided an optical system characterized in that the direction of the fast axis in regard to variation of birefringence of said optically transparent member when subjected to optical illumination is set so as to substantially coincide with or to be substantially orthogonal to the direction of oscillation of the electrical field of the input linearly polarized light to said optically transparent member.

According to a second aspect of the present invention, there is provided illumination optical equipment characterized in that it comprises an optical system according to the first aspect and in that the surface to be illuminated is illuminated by light through this optical system.

According to a third aspect of the present invention, in illumination optical equipment including an optically transparent member formed of a crystalline material of the cubic system and wherein a surface to be illuminated is illuminated with light through this optically transparent member, there is provided illumination optical equipment characterized in that the direction of propagation of light in said optically transparent member is set so as to be closer to the crystal orientation < 111 > or crystal orientation < 100 > than to the crystal orientation < 110 >.

In a preferred mode of the third aspect, said optically transparent member comprises an optical member fixedly located in position in the optical path and the optical axis of said optical member is set so as to substantially coincide with the crystal orientation < 111 > or crystal orientation < 100 >. Also, in the third aspect, preferably said optically transparent member comprises a prism which is set such that the input face and output face of said prism substantially coincide with the crystallographic plane {100}. Alternatively, preferably said optically transparent member comprises a prism which is set such that the input face and output face of said prism substantially coincide with the crystallographic plane {111}. Alternatively, preferably said optically transparent member comprises a prism which is set such that one face of the input face and output face of said prism substantially coincides with the crystallographic plane {111} and the other face substantially coincides with the crystallographic plane {100} or the crystallographic plane {211}.

Also, in a preferred mode of the third aspect, said optically transparent member comprises a right-angled prism constituting an internal-face reflecting mirror which is set such that the reflecting face of said right-angled prism substantially coincides with the crystallographic plane {100} and such that the plane defined by the optical axis of the input face of said right-angled prism and the optical axis of the output face of said right-angled prism substantially coincides with the crystallographic plane {110}. Alternatively, preferably said optically transparent member comprises a right-angled prism constituting an internal-face reflecting mirror which is set such that the reflecting face of said right-angled prism and the plane defined by the optical axis of the input face of said right-angled prism and the optical axis of the output face of said right-angled prism both substantially coincide with the crystallographic plane {110}.

Also, in a preferred mode of the third aspect, said optically transparent member comprises a parallel planar plate for parallel displacement of a light ray that is incident along said optical axis, provided capable of being tilted with respect to the optical axis in said optical path, wherein the optical axis of said parallel planar plate is set so as to substantially coincide with the crystal orientation < 100 >. In this case, preferably said parallel planar plate is capable of being tilted in a direction from the crystal orientation < 100 > towards the crystal orientation < 111 >.

Also, according to a preferred mode of the third aspect, said optically transparent member comprises a parallel planar plate for parallel movement of a light ray that is input along said optical axis, provided capable of being tilted with respect to the optical axis in said optical path, wherein the optical axis of said parallel planar plate is set so as to substantially coincide with the crystal orientation < 111 >. In this case, preferably said parallel planar plate is capable of being tilted in a direction from the crystal orientation < 111 > towards the crystal orientation < 100 >.

Also, according to a preferred mode of the third aspect, said optically transparent member comprises a first parallel planar plate capable of being tilted about a first axis and a second parallel planar plate capable of being tilted about a second axis substantially orthogonal to said first axis. Also, in the third aspect, preferably the direction of the fast axis in regard to the variation of birefringence of said optically transparent member when subjected to optical illumination is set so as to substantially coincide or to be substantially orthogonal to the direction of oscillation of the electrical field of the linearly polarized light incident on said optically transparent member.

In a fourth aspect of the present invention, there is provided exposure equipment characterized in that it comprises illumination optical equipment according to the second aspect or third aspect wherein a mask pattern is exposed onto a photosensitive substrate arranged on said illuminated face.

In a fifth aspect of the present invention, there is provided an exposure method characterized in that a mask is illuminated through exposure optical equipment according to the second aspect or third aspect and the pattern formed on said illuminated mask is thus exposed onto a photosensitive substrate.

Beneficial effect of the invention

Since, in an optical system and illumination optical equipment according to the present invention, the direction of the fast axis in regard to variation of birefringence of an optically transparent member formed by crystalline material of the cubic system such as for example fluorite is set so as to substantially coincide with or to be substantially orthogonal to the direction of oscillation of the electrical field of the input linearly polarized light to the optically transparent member, changes in the polarization condition of the linearly polarized light passing through the optically transparent member can be suppressed. Consequently, if illumination optical equipment according to the present invention is mounted for example in exposure equipment, appropriate illumination conditions can be achieved by changing the condition of polarization of the illuminating light in accordance with the pattern characteristics of the mask.

Also, with exposure equipment and an exposure method employing illumination optical equipment according to the present invention, since appropriate illumination conditions can be achieved by changing the condition of polarization of the illuminating light in accordance with the pattern characteristics of the mask, excellent exposure can be performed under appropriate illumination conditions realised in accordance with the pattern characteristics of the mask and hence excellent devices can be manufactured with high throughput.

Brief description of the drawings

[Figure 1] This is a view showing diagrammatically the construction of exposure equipment comprising illumination optical equipment according to an embodiment of the present invention.

[Figure 2] This is a view showing a secondary light source of annular form and a secondary light source of quadrupole form formed for annular illumination and quadrupole illumination.

[Figure 3] This is a view showing a secondary light source of dipole form formed for dipole illumination.

[Figure 4] This is a view showing diagrammatically the construction of the phase member and depolarizer of Figure 1.

[Figure 5] This is a view showing diagrammatically the layout of polarization condition changeover means according to a first modified example.

[Figure 6] This is a view showing diagrammatically the construction of polarization condition changeover means according to a second modified example.

[Figure 7] This is a view showing diagrammatically the construction of polarization condition changeover means according to a third modified example.

[Figure 8] This is a view showing diagrammatically the construction of a depolarizer according to a modified example.

[Figure 9] This is a view showing diagrammatically the internal construction of a beam matching unit arranged between the light source and polarization condition changeover means in Figure 1.

[Figure 10] This is a view showing crystal orientation of fluorite.

[Figure 11] This is a view showing diagrammatically an example in which a 1/4 wavelength plate is additionally provided in the polarization condition changeover means, for conversion of elliptically polarized light to linearly polarized light.

[Figure 12] This is a flow chart of a technique employed when obtaining a semiconductor device, constituting an example of a microdevice.

[Figure 13] This is a flow chart of a technique employed when obtaining a liquid crystal display element, constituting an example of a microdevice.

[Figure 14] This is a view showing how the polarization condition of the light is changed when linearly polarized incident light passes through a birefringent medium.

[Figure 15] This is a view corresponding to Figure 10 given in explanation of another method of representation of crystal orientation of fluorite.

[Figure 16] This is a view showing diagrammatically the change in amount of birefringence variation in fluorite when the crystal orientation is varied between [001] and [110] and ArF excimer laser light is incident thereon, along this crystal orientation.

[Figure 17] This is a view showing diagrammatically the change in amount of birefringence variation in fluorite when the crystal orientation is varied between [001] and [100] and ArF excimer laser light is incident thereon, along this crystal orientation.

[Figure 18] This is a view corresponding to Figure 16 showing diagrammatically the change in amount of birefringence variation in fluorite when incident light of very high energy density is incident thereon.

[Figure 19] This is a view given in explanation of an example relating to the setting of crystal orientation in a right-angled prism.

[Figure 20] This is a view given in explanation of a further example relating to the setting of crystal orientation in a right-angled prism.

[Figure 21] This is a view given in explanation of yet a further example relating to the setting of crystal orientation in a right-angled prism.

[Figure 22] This is a view given in explanation of yet a further example relating to the setting of crystal orientation in a right-angled prism.

[Figure 23] This is a view given in explanation of the arrangement of crystal orientation as seen from the direction of crystal orientation < 100 >.

[Figure 24] This is a view given in explanation of the arrangement of crystal orientation as seen from the direction of crystal orientation < 111>.

Best mode for performing the invention

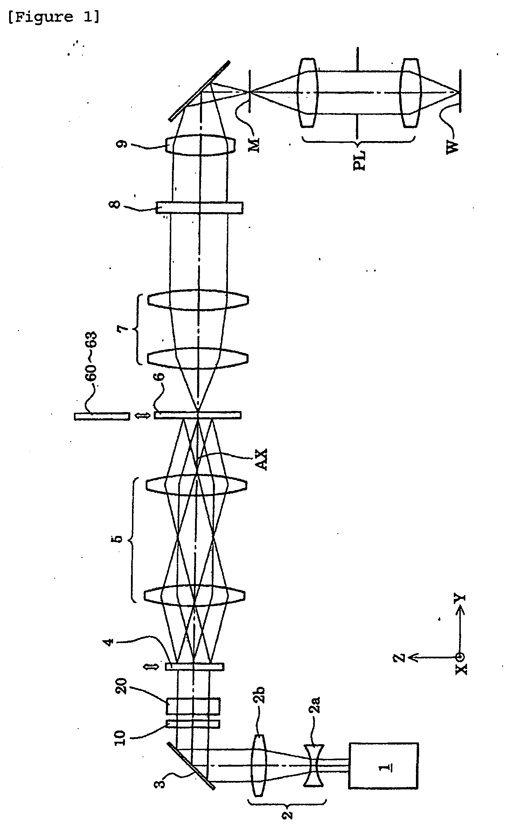

Embodiments of the present invention are described below with reference to the appended drawings. Figure 1 is a view showing diagrammatically the construction of exposure equipment and comprising illumination optical equipment according to an embodiment of the present invention. In Figure 1, there are respectively set up a Z axis along the direction of the normal to a wafer W constituting a photosensitive substrate, a Y axis in the wafer surface in a direction parallel with the plane of the drawing of Figure 1, and an X axis in the wafer surface in a direction perpendicular to the plane of the drawing of Figure 1. It should be noted that, in Figure 1, the illumination optical equipment is set so as to perform annular illumination.

The exposure equipment according to this embodiment comprises a laser light source 1 for supplying exposure light (illumination light). As the laser light source 1, there may be employed for example a KrF excimer laser light source that supplies light of wavelength 248 nm or an ArF excimer laser light source that supplies light of wavelength 193 nm. The substantially parallel optical flux emitted along the Z direction from the laser light source 1 has a rectangular cross section extending in elongate fashion along the X direction and is input to a beam expander 2 comprising a pair of lenses 2a and 2b. The lenses 2a and 2b respectively have negative refractive power and positive refractive power in the plane of the drawing of Figure 1 (in the YZ plane). Consequently, the optical flux that is input to the beam expander 2 is expanded in the plane of the drawing of Figure 1 and is shaped to an optical flux having a prescribed rectangular cross section.

The substantially parallel optical flux that has passed through the shaping optical system constituted by the beam expander 2 is deflected in the Y direction by a bending mirror 3 and is then input to an afocal zoom lens 5 through a phase member 10, depolarizer 20 and optical diffraction element 4. The construction and action of the phase member 10 and depolarizer 20 will be described later. Typically, the optical diffraction element is constituted by forming steps having a pitch of the order of the wavelength of the exposure light (illumination light) on a substrate and has the action of deflecting an incident beam by a desired angle. Specifically, when parallel optical flux having a cross section of rectangular shape is incident thereon, the optical diffraction element 4 has the function of forming an optical intensity distribution of circular shape on the far field (or Fraunhofer diffraction region) thereof.

Consequently, the optical flux that has passed through the optical diffraction element 4 forms an optical flux having a circular optical intensity distribution i.e. a circular cross section in the pupil position of the afocal zoom lens 5. The optical diffraction element 4 is arranged to be capable of being retracted from the illumination optical path. The afocal zoom lens 5 is constructed so as to be capable of continuous change of magnification factor in a prescribed range while maintaining an afocal system. The optical flux that has passed through the afocal zoom lens 5 is input to an optical diffraction element 6 for annular illumination. In the afocal zoom lens 5, the emission origin of the optical diffraction element 4 and the diffraction plane of the optical diffraction element 6 are coupled in substantially optically conjugate fashion. Also, the numerical aperture of the optical flux that is focussed on the diffraction plane of the optical diffraction element 6 or a point of the plane in the vicinity thereof changes depending on the magnification factor of the afocal zoom lens 5.

If parallel optical flux is input, the annular illumination optical diffraction element 6 has the function of forming an optical intensity distribution of ring shape in the far field. The optical diffraction element 6 is constructed so as to be capable of being freely inserted into the illumination optical path and is constructed so as to make possible changeover of an optical diffraction element 60 for quadrupole illumination or an optical diffraction element 61 for circular illumination or an optical diffraction element 62 for X-direction dipole illumination or an optical diffraction element 63 for Y-direction dipole illumination. The construction and action of the optical diffraction element 60 for quadrupole illumination or optical diffraction element 61 for circular illumination or optical diffraction element 62 for X-direction dipole illumination or optical diffraction element 63 for Y-direction dipole illumination will be described later.

The optical flux that has passed through the optical diffraction element 6 is input to the zoom lens 7. The input face of the microlens array (or fly-eye lens) 8 is located in position in the vicinity of the focal plane on the rear side of the zoom lens 7. The microlens array 8 is an optical element comprising a large number of minute lenses having positive refractive power densely arranged vertically and horizontally. Typically, the microlens array is constituted by forming a group of minute lenses for example by performing etching treatment on a parallel planar plate.

The minute lenses constituting the microlens array are more minute than the lens elements constituting a fly-eye lens. Also, in a microlens array, in contrast to a fly-eye lens, which is constituted by mutually isolated lens elements, a large number of minute lenses (minute diffraction faces) are integrally formed that are not mutually isolated. However, a microlens array is a wave-surface-division-type optical integrator like a fly-eye lens in that lens elements having positive refractive power are arranged vertically and horizontally.

As described above, the optical flux from the circular optical intensity distribution formed in the pupil position of the afocal zoom lens 5 through the optical diffraction element 4 is emitted from the afocal zoom lens 5 and then constitutes optical flux having various angular components that are input to the optical diffraction element 6. Specifically, the optical diffraction element 4 constitutes an optical integrator having an angular optical flux formation function. In contrast, the optical diffraction element 6 has the function of a flux conversion element that forms a ringshaped optical intensity distribution in the far field thereof when parallel optical flux is input thereto. Consequently, the optical flux that has passed through the optical diffraction element 6 forms for example an annular illumination field centered on an optical axis AX at the rear-side focal plane (and hence, the input plane of the microlens array 8) of the zoom lens 7.

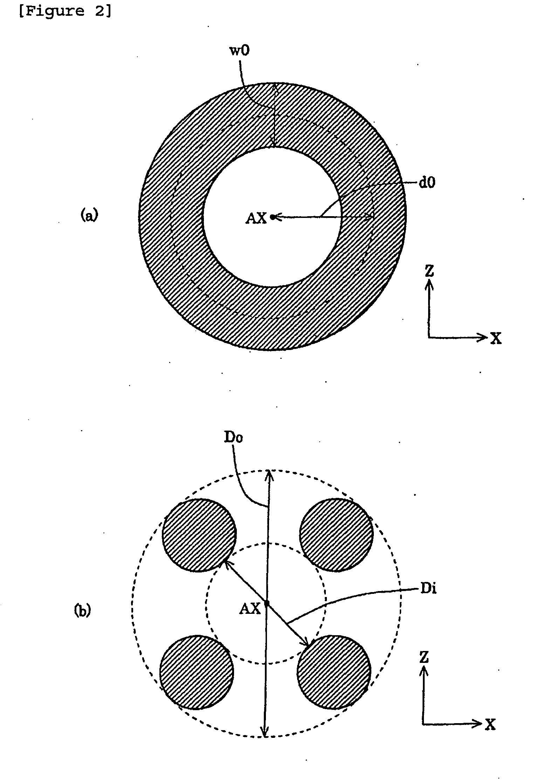

The external diameter of the annular illumination field formed at the input plane of the microlens array 8 changes depending on the focal point distance of the zoom lens 7. In this way, the zoom lens 7 couples the optical diffraction element 6 and the input plane of the microlens array 8 in substantially a Fourier transformation relationship. As shown in Figure 2(a), the optical flux that is input to the microlens array 8 is, just like the illumination field formed by the input optical flux, two-dimensionally divided so that a large number of annular light sources (hereinbelow referred to as "secondary light sources") are formed at the rear-side focal plane of the microlens array 8.

After the optical flux from the annular secondary light sources formed at the rear-side focal plane of the microlens array 8 has been subjected to the focusing action of the condenser optical system 9, it illuminates in superimposed fashion a mask M that is formed with a prescribed pattern. The optical flux that passes through the pattern of the mask M forms an image of the mask pattern on a wafer W constituting a photosensitive substrate, by means of a projection optical system PL. In this way, by performing simultaneous exposure or scanning exposure while performing two-dimensional drive control of the wafer W within a plane (XY plane) orthogonal to the optical axis AX of the projection optical system PL, the pattern of the mask M is excessively exposed in the various exposure regions of the wafer W.

In this embodiment, when the magnification factor of the afocal zoom lens 5 is changed, the center heights of the annular secondary light sources (distance of the center line of the circular shape from the optical axis AX) dO are unchanged; only their widths (1/2 of the difference of the external diameter (diameter) and internal diameter (diameter)) w0 are changed. Specifically, by changing the magnification factor of the afocal zoom lens 5, the size (external diameter) and shape (annular ratio: internal diameter/external diameter) of the annular secondary light sources can both be altered.

Also, when the focal distance of the zoom lens 7 is changed, the center heights d0 of the annular secondary light sources are unchanged; only their widths w0 are changed. Specifically, by changing the focal distance of the zoom lens 7, it is possible to alter the external diameters of the annular secondary light sources, without altering their annular ratio. From the above, in this embodiment, by suitably altering the magnification factor of the afocal zoom lens 5 and the focal distance of the zoom lens 7, it is possible to alter only the annular ratios of the annular secondary light sources, without altering their external diameters.

It should be noted that it is possible to perform quadrupole illumination by setting an optical diffraction element 60 in the illumination optical path, instead of the optical diffraction element 6. Such an optical diffraction element 60 for quadrupole illumination, if parallel optical flux is incident thereon, has the function of forming an optical intensity distribution of quadrupole form in the far field. Consequently, the optical flux that has passed through the optical diffraction element 60 forms a quadrupole illumination field comprising for example four illumination fields of circular shape centered on the optical axis AX in the incident plane of the microlens array 8. As a result, as shown in Figure 2(b), quadrupole secondary light sources as in the illumination field formed in the incident plane are also formed in the rear-side focal plane of the microlens array 8.

In quadrupole illumination also, just as in the case of annular illumination, by changing the magnification factor of the afocal zoom lens 5, it is possible to alter both the external diameter Do of the quadrupole secondary light sources (diameter of the circumscribed circle of the four circular planar light sources) and annular ratio thereof (diameter Di of the inscribed circle of the four circular planar light sources/diameter Do of the circumscribed circle of the four circular planar light sources). Also, by changing the focal distance of the zoom lens 7, it is possible to alter the external diameter of the quadrupole secondary light sources without altering the annular ratio thereof. As a result, it is possible to alter only the annular ratio of the quadrupole secondary light sources without changing the external diameter thereof, by suitably changing the magnification factor of the afocal zoom lens 5 and the focal distance of the zoom lens 7.

Also, it is possible to perform ordinary circular illumination by withdrawing the optical diffraction element 4 from the illumination optical path and setting an optical diffraction element 61 for circular illumination in the illumination optical path in place of the optical diffraction element 6 or 60. In this case, optical flux having a rectangular cross section along the optical axis AX is input to the afocal zoom lens 5. The optical flux that is input to the afocal zoom lens 5 is expanded or contracted in accordance with the magnification factor and is emitted from the afocal zoom lens 5 along the optical axis AX still in the form of optical flux having a rectangular cross section and is then input to the optical diffraction element 61.

Like the optical diffraction element 4, the optical diffraction element 61 for circular illumination has the function of forming a circular optical intensity distribution in the far field when parallel optical flux having a rectangular cross section is input thereto. The circular optical flux formed by the optical diffraction element 61 therefore forms a circular illumination field centered on the optical axis AX at the incident plane of the microlens array 8 after passing through the zoom lens 7. As a result, a circular secondary light source centered on the optical axis is also formed in the rear-side focal plane of the microlens array 8. In this case, the external diameter of the circular secondary light source can be appropriately altered by changing the magnification factor of the afocal zoom lens 5 or the focal distance of the zoom lens 7.

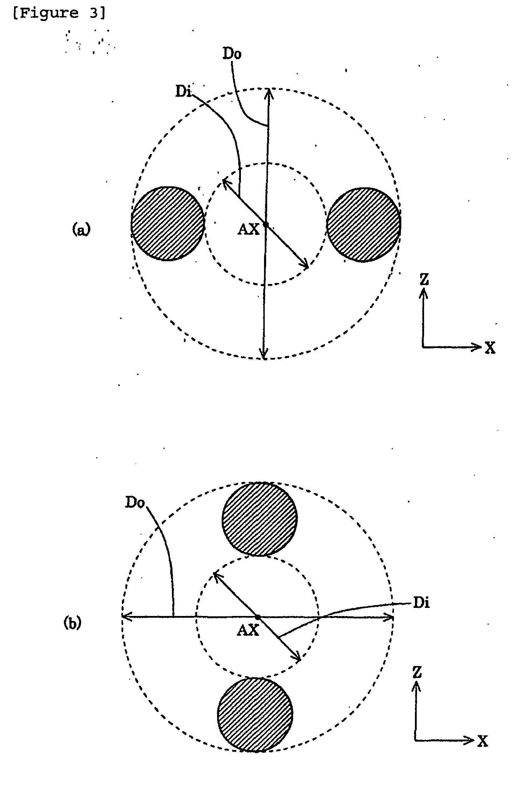

In addition, X-direction dipole illumination can be performed by setting an optical diffraction element 62 in the illumination optical path in place of the optical diffraction elements 6, 60 or 61. The optical diffraction element 62 for X-direction dipole illumination has the function of forming a dipole optical intensity distribution separated by an interval in the X direction in the far field when parallel optical flux is input thereto. Consequently, the optical flux that has passed through the optical diffraction element 62 forms for example a dipole illumination field comprising two circular illumination fields separated by an interval along the X direction and centered on the optical axis AX at the incident plane of the microlens array 8. As a result, as shown in Figure 3(a), a dipole secondary light source is also formed at the rear-side focal plane of the microlens array 8 along the X direction in the same way as the illumination field formed at the incident plane thereof.

Also, Y-direction dipole illumination can be performed by setting an optical diffraction element 63 in the illumination optical path in place of the optical diffraction elements 6, 60, 61 or 62. The optical diffraction element 63 for Y-direction dipole illumination has the function of forming a dipole optical intensity distribution with an interval along the Z direction (corresponding to the Y direction on the mask or on the wafer) in the far field when parallel optical flux is input thereto. Consequently, the optical flux that has passed through the optical diffraction element 63 forms for example a dipole illumination field comprising two circular illumination fields separated by an interval along the Z direction centered on the optical axis AX at the incident plane of the microlens array 8. As a result, as shown in Figure 3(b), a dipole secondary light source is also formed in the rear-side focal plane of the microlens array 8 along the Z direction, in the same way as the illumination field formed on the incident plane.

In dipole illumination also, in the same way as in the case of quadrupole illumination, it is possible to alter both the external diameter of the dipole secondary light source (diameter of the circle circumscribed on the two circular planar light sources) do and the annular ratio (diameter di of the inscribed circle on the two circular planar light sources/diameter do of the circumscribed circle at the two circular planar light sources), by changing the magnification factor of the afocal zoom lens 5. Also, by changing the focal distance of the zoom lens 7, the external diameter can be altered without altering the annular ratio of the dipole secondary light source. As a result, by suitably changing the magnification factor of the afocal zoom lens 5 and the focal distance of the zoom lens 7, only this annular ratio can be altered, without changing the external diameter of the dipole secondary light source.

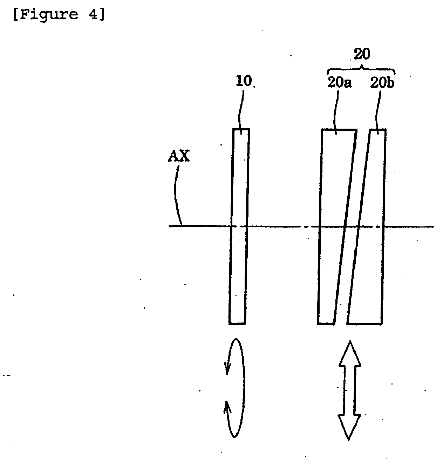

Figure 4 is a view showing diagrammatically the construction of the phase member and depolarizer of Figure 1. Referring to Figure 4, the phase member 10 is constructed by a 1/2 wavelength plate arranged with its crystal optical axis freely rotatable about the optical axis AX. The depolarizer 20 is constituted by a wedge-shaped quartz crystal prism 20a and a wedge-shaped silica glass prism 20b having a shape complementary with this quartz crystal prism 20a. The quartz crystal prism 20a and silica glass prism 20b constitute an integral prism assembly that is arranged to be freely inserted into or withdrawn from the illumination optical path. Linearly polarized light is input to the 1/2 wavelength plate 10 when a KrF excimer laser light source or ArF excimer laser light source is employed as the laser light source 1.

If the crystal optical axis of the 1/2 wavelength plate 10 is set so as to present an angle of 0° or 90° with respect to the plane of polarization of the incoming linearly polarized light, the linearly polarized light that is input to the 1/2 wavelength plate 10 is directly transmitted with no alteration in its plane of polarization. Also, if the crystal optical axis of the 1/2 wavelength plate 10 is set so as to present an angle of 45° with respect to the plane of polarization of the incoming linearly polarized light, this linearly polarized light that is incident on the 1/2 wavelength plate 10 is converted to linearly polarized light whose plane of polarization has been changed by 90°. Furthermore, if the crystal optical axis of the quartz crystal prism 20a is set so as to present an angle of 45° with respect to the plane of polarization of the incoming linearly polarized light, this linearly polarized light that is incident on the quartz crystal prism 20a is converted to light in a non-polarized condition (i.e. it is depolarized).

In this embodiment, the arrangement is such that, when the depolarizer 20 is located in position in the illumination optical path, the crystal optical axis of the quartz crystal prism 20a makes an angle of 45° with respect to the plane of polarization of the incoming linearly polarized light. Incidentally, if the crystal optical axis of the quartz crystal prism 20a is set so as to make an angle of 0° or 90° with respect to the plane of polarization of the incoming linearly polarized light, this linearly polarized light that is incident on the quartz crystal prism 20a will be transmitted with its plane of polarization unchanged. Also, if the crystal optical axis of the 1/2 wavelength plate 10 is set so as to make an angle of 22.5° with respect to the plane of polarization of the incoming linearly polarized light, this linearly polarized light that is incident on the 1/2 wavelength plate 10 will be converted into light of a non-polarized condition, containing a linearly polarized component that is directly transmitted without change of its plane of polarization and a linearly polarized component whose plane of polarization has been changed by 90°.

In this embodiment, as described above, linearly polarized light from the laser light source 1 is input to the 1/2 wavelength plate 10, but, in order to simplify the following description, it will be assumed that P-polarized light is input to the 1/2 wavelength plate 10. If the depolarizer 20 is located in position in the illumination optical path, if the crystal optical axis of the 1/2 wavelength plate 10 is set so as to make an angle of 0° or 90° with respect to the plane of polarization of the incoming P-polarized light, this P-polarized light that is incident on the 1/2 wavelength plate 10 will be transmitted unaltered as P-polarized light, without change of its plane of polarization and will thus be incident in this condition on the quartz crystal prism 20a. Since the crystal optical axis of the quartz crystal prism 20a is set so as to make an angle of 45° with respect to the plane of polarization of the incoming P-polarized light, this P-polarized light that is incident on the quartz crystal prism 20a is converted to light in a non-polarized condition.

The P-polarized light that has passed through this quartz crystal prism 20a illuminates the mask M (and hence the wafer W) in a non-polarized condition through the silica glass prism 20b, that acts as a compensator for compensating the direction of propagation of the light. If the crystal optical axis of the 1/2 wavelength plate 10 is set so as to make an angle of 45° with respect to the plane of polarization of the incoming P-polarized light, this P-polarized light that is incident on the 1/2 wavelength plate 10 has its plane of polarization changed by 90°, thereby becoming S-polarized light, which is input to the quartz crystal prism 20a. Since the crystal optical axis of the quartz crystal prism 20a is set so as to make an angle of 45° with respect to the plane of polarization of the incoming S-polarized light, this S-polarized light that is incident on the quartz crystal prism 20a is converted to light of a non-polarized condition and illuminates the mask M in a non-polarized condition through the silica glass prism 20b.

In contrast, when the depolarizer 20 is withdrawn from the illumination optical path, if the crystal optical axis of the 1/2 wavelength plate 10 is set so as to make an angle of 0° or 90° with respect to the plane of polarization of the incoming P-polarized light, the P-polarized light that is incident on the 1/2 wavelength plate 10 is directly transmitted as P-polarized light without its plane of polarization being changed, so the mask M is illuminated with light in a P-polarized condition. On the other hand, if the crystal optical axis of the 1/2 wavelength plate 10 is set so as to make an angle of 45° with respect to the plane of polarization of the incoming P-polarized light, this P-polarized light that is incident on the 1/2 wavelength plate 10 has its plane of polarization changed by 90°, becoming S-polarized light, and the mask M is thus illuminated with light in an S-polarized condition.

As described above, in this embodiment, the mask M can be illuminated in a non-polarized condition by inserting and locating in position the depolarizer 20 in the illumination optical path. Also, the mask M can be illuminated in a P-polarized condition by withdrawing the depolarizer 20 from the illumination optical path and setting such that the crystal optical axis of the 1/2 wavelength plate 10 makes an angle of 0° or 90° with respect to the plane of polarization of the incoming P-polarized light. Further, the mask M can be illuminated in an S-polarized condition by withdrawing the depolarizer 20 from the illumination optical path and setting such that the crystal optical axis of the 1/2 wavelength plate 10 makes an angle of 45° with respect to the plane of polarization of the incoming P-polarized light.

In other words, in this embodiment, by action of the polarization condition changeover means comprising the 1/2 wavelength plate 10 and depolarizer 20, the condition of polarization of the light that illuminates the illuminated surface constituted by the mask M (and hence the wafer W) can be changed over between a linearly polarized condition and non-polarized condition and, in the case of illumination with light in a linearly polarized condition, can be changed over between a P-polarized condition and S-polarized condition (the plane of polarization of the linearly polarized light can be altered). As a result, in this embodiment, appropriate illumination conditions can be achieved by changing the polarization condition of the illuminating light in accordance with the pattern characteristics of the mask M, so excellent exposure can be performed under appropriate illumination conditions realized in accordance with the pattern characteristics of the mask M.

Specifically, by for example setting dipole illumination in the X direction and illuminating the mask M with light in linearly polarized condition having a plane of polarization along the X direction on the mask M, a pattern with extremely small line width along the X direction can be faithfully exposed in the critical layer on the wafer W. Then, for example by changing over to dipole illumination in the Y direction, and illuminating the mask M with light in a linearly polarized condition having a plane of polarization along the Y direction at the mask M, a pattern with extremely small line width along the Y direction can likewise be faithfully exposed in the critical layer on the wafer W.

Furthermore, after a double exposure in the critical layer has been completed, by for example continuing to use dipole illumination, or by changing over to quadrupole illumination or annular illumination or circular illumination and illuminating the mask M with light in non-polarized condition, a two-dimensional pattern of comparatively large line width can be exposed with high throughput in a non-critical layer (middle layer or rough layer) on the wafer W. This is only an example and, typically, excellent exposure can be performed under appropriate illumination conditions by setting a suitable shape or size for the secondary light source in accordance with the pattern characteristics of the mask M, and setting the light that illuminates the mask M to an appropriate polarization condition.

In fact, dispersion at the surface of the resist layer formed on the wafer W is different in the case of inclined incidence of P-polarized light rays and in the case of inclined incidence of S-polarized light rays. Specifically, the reflectivity for S-polarized light is higher than for P-polarized light, so P-polarized light penetrates more deeply into the interior of the resist layer than S-polarized light. If appropriate illumination conditions are realised by changing the polarization condition of the illuminating light in accordance with the pattern characteristics of the mask M by utilising this difference of optical characteristics of P-polarized light and S-polarized light in regard to the resist layer, excellent exposure can be performed under appropriate illumination conditions.

It will be noted that, in the embodiment described above, the 1/2 wavelength plate 10 constituting the phase member for changing the plane of polarization of the incoming linearly polarized light as required was arranged on the light source side whereas the depolarizer 20 for depolarizing the incoming linearly polarized light as required was arranged on the mask side. However, there is no restriction to this and the same beneficial optical effects can be obtained by arranging the depolarizer 20 on the light source side and arranging the 1/2 wavelength plate 10 on the mask side.

Also, in the embodiment described above, a silica glass prism 20b is employed as a compensator for compensating the direction of propagation of the light that has passed through the quartz crystal prism 20a. However, there is no restriction to this and it would also be possible to employ as a compensator a wedge-shaped prism formed of an optical material of high endurance in respect of KrF excimer laser light or ArF excimer laser light, such as for example quartz crystal or silica glass. This also applies to the other related modified examples.

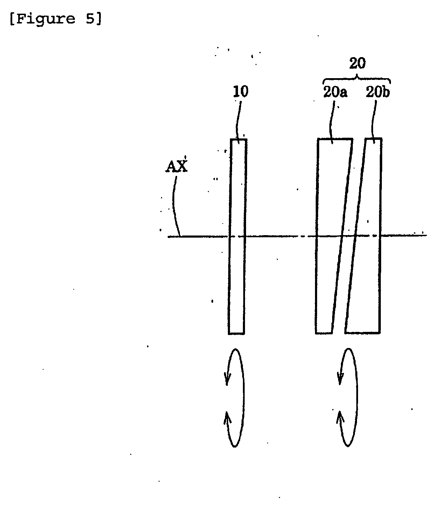

Figure 5 is a view showing diagrammatically the construction of polarization condition changeover means according to a first modified example. The polarization condition changeover means according to the first modified example of Figure 5 has a similar construction to the polarization condition changeover means according to the embodiment of Figure 4. However, their basic difference lies in the fact that, whereas, in the case of the embodiment of Figure 4, the depolarizer 20 is constructed so as to be capable of being freely inserted or withdrawn with respect to the illumination optical path, in the first modified example of Figure 5, the quartz crystal prism 20a and silica glass prism 20b that constitute the depolarizer 20 are integrally constructed so as to be freely rotatable about the optical axis AX, and hence are constructed such that the crystal optical axis of the quartz crystal prism 20a is freely rotatable about the optical axis AX. The first modified example of Figure 5 is described below focusing on the differences with respect to the embodiment of Figure 4.

In the first modified example, when the crystal optical axis of the 1/2 wavelength plate 10 is set such as to make an angle of 0° or 90° with respect to the plane of polarization of the incoming P-polarized light, this P-polarized light that is incident on the 1/2 wavelength plate 10 is transmitted therethrough remaining in a P-polarized condition, with its plane of polarization unchanged, and is then input to the quartz crystal prism 20a. If the crystal optical axis of the quartz crystal prism 20a is then set so as to make an angle of 45° with respect to the plane of polarization of the incoming P-polarized light, the P-polarized light that is thus incident on the quartz crystal prism 20a is converted to light in a non-polarized condition, with the result that the mask M is illuminated in a non-polarized condition through the silica glass prism 20b. Also, if the crystal optical axis of the quartz crystal prism 20a is set so as to make an angle of 0° or 90° with respect to the plane of polarization of the incoming P-polarized light, the P-polarized light that is thus incident on the quartz crystal prism 20a is directly transmitted, while remaining in a P polarization condition i.e. with no change in its plane of polarization, before illuminating the mask M in a P polarization condition through the silica glass prism 20b.

Furthermore, if the crystal optical axis of the 1/2 wavelength plate 10 is set so as to make an angle of 45° with respect to the plane of polarization of the incoming P-polarized light, the P-polarized light that is incident on the 1/2 wavelength plate 10 has its plane of polarization changed by 90°, becoming S-polarized light, which is input to the quartz crystal prism 20a. If, at this point, the crystal optical axis of the quartz crystal prism 20a is set so as to make an angle of 45° with respect to the plane of polarization of the incoming P-polarized light, this S-polarized light that is incident on the quartz crystal prism 20a is converted to light in a non-polarized condition and the mask M is therefore illuminated in a non-polarized condition through the silica glass prism 20b. However, if the crystal optical axis of the quartz crystal prism 20a is set so as to make an angle of 0° or 90° with respect to the plane of polarization of the incoming S-polarized light, this S-polarized light that is incident on the quartz crystal prism 20a is transmitted while still remaining as S-polarized light i.e. with its plane of polarization unchanged and the mask M is therefore illuminated in an S-polarized condition through the silica glass prism 20b.

As described above, with the first modified example of Figure 5, by a combination of rotation of the 1/2 wavelength plate 10 about the optical axis AX and rotation of the quartz crystal prism 20a about the optical axis AX, the polarization condition of the light that illuminates the mask M can be changed over between a linearly polarized condition and a non-polarized condition, and, in the case of illumination with linearly polarized light, can be changed over between a P-polarized condition and an S-polarized condition. It should be noted that, also in the case of the first modified example of Figure 5, the 1/2 wavelength plate 10 is arranged on the light source side and the depolarizer 20 is arranged on the mask side, but the same optical beneficial effects could be obtained by arranging the depolarizer 20 on the light source side and arranging the 1/2 wavelength plate 10 on the mask side.

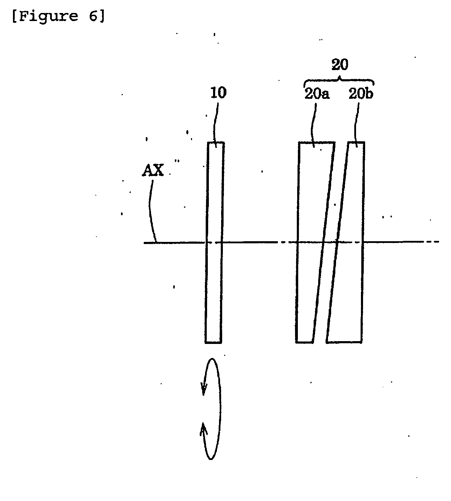

Figure 6 is a view showing diagrammatically the construction of polarization condition changeover means according to a second modified example. The polarization condition changeover means according to the second modified example of Figure 6 has a similar construction to the polarization condition changeover means according to the embodiment of Figure 4. However, whereas, in the case of the embodiment of Figure 4, the depolarizer 20 is constructed so as to be freely inserted or withdrawn with respect to the illumination optical path, in the case of the second modified example of Figure 6, the depolarizer 20 differs fundamentally in that it is located in position in fixed fashion in the illumination optical path. The second modified example of Figure 6 is described below focusing on the differences with respect to the embodiment of Figure 4.

In the second modified example, the crystal optical axis of the quartz crystal prism 20a is located in position so as to make an angle of 0° or 90° with respect to the plane of polarization of the incoming P-polarized light. Consequently, if the crystal optical axis of the 1/2 wavelength plate 10 is set so as to make an angle of 0° or 90° with respect to the plane of polarization of the incoming P-polarized light, the P-polarized light that is incident on the 1/2 wavelength plate 10 is transmitted unchanged as P-polarized light i.e. without its plane of polarization being changed and is thus input to the quartz crystal prism 20a. Since the crystal optical axis of the quartz crystal prism 20a is located in position so as to make an angle of 0° or 90° with respect to the plane of polarization of the incoming P-polarized light, the P-polarized light that is incident on the quartz crystal prism 20a is transmitted with its P polarization unchanged i.e. without change of its plane of polarization and the mask M is thus illuminated in a P-polarized condition through the silica glass prism 20b.

Also, if the crystal optical axis of the 1/2 wavelength plate 10 is set so as to make an angle of 45° with respect to the plane of polarization of the incoming P-polarized light, the P-polarized light that is incident on the 1/2 wavelength plate 10 has its plane of polarization changed by 90°, becoming S-polarized light which is then input to the quartz crystal prism 20a. Since the crystal optical axis of the quartz crystal prism 20a is located in position so as to make an angle of 0° or 90° with respect to the plane of polarization of the incoming S-polarized light, the S-polarized light that is incident on the quartz crystal prism 20a is transmitted with its S polarization unchanged i.e. with no change in plane of polarization and the mask M is illuminated in S-polarized condition through the silica glass prism 20b.

Furthermore, if the crystal optical axis of the 1/2 wavelength plate 10 is set so as to make an angle of 22.5° with respect to the plane of polarization of the incoming P-polarized light, as described above, the P-polarized light that is incident on the 1/2 wavelength plate 10 is converted to light of a non-polarized condition containing a P-polarized component that is transmitted unchanged i.e. without change to its plane of polarization and an S-polarized component whose plane of polarization is changed by 90° and is thus input to the quartz crystal prism 20a. Since the crystal optical axis of the quartz crystal prism 20a is located in position so as to make an angle of 0° or 90° with respect to the plane of polarization of the incoming P-polarized component and with respect to the plane of polarization of the incoming S-polarized component, the P-polarized component and the S-polarized component that are input to the quartz crystal prism 20a are transmitted with no change in their planes of polarization and the mask M is thus illuminated in a non-polarized condition through the silica glass prism 20b.

As described above, in the second modified example of Figure 6, by suitably rotating the 1/2 wavelength plate 10 about the optical axis AX in a condition with the depolarizer 20 located fixedly in position in the illumination optical path, it is possible to change over the polarization condition of the light that illuminates the mask M between a linearly polarized condition and non-polarized condition and, in the case where illumination is effected with light in a linearly polarized condition, it is possible to change over between a P-polarized condition and an S-polarized condition. It should be noted that, although, in the second modified example of Figure 6 also, the 1/2 wavelength plate 10 is arranged on the light source side and the depolarizer 20 is arranged on the mask side, the same optical beneficial effect could be obtained by arranging the depolarizer 20 on the light source side and arranging the 1/2 wavelength plate 10 on the mask side.

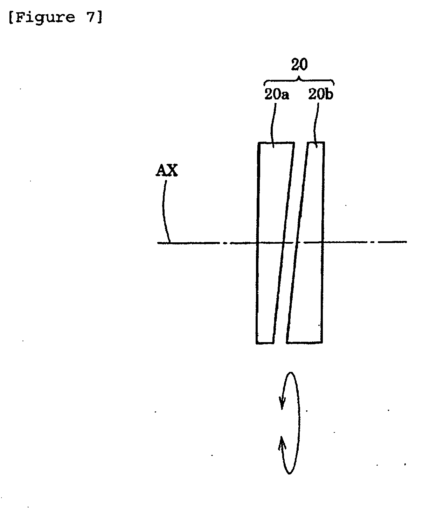

Figure 7 is a view showing diagrammatically the construction of polarization condition changeover means according to a third modified example. The polarization condition changeover means of the third modified example of Figure 7 has a construction similar to the polarization condition changeover means according to the first modified example of Figure 5. However, whereas, in the case of the first modified example of Figure 5, the polarization condition changeover means was constructed by a 1/2 wavelength plate 10 and depolarizer 20, in the case of the third modified example of Figure 7, the polarization condition changeover means differs fundamentally in that it is constructed solely by means of a depolarizer 20 that is freely rotatable about the optical axis AX. The third modified example of Figure 7 is described below focusing on the differences from the first modified example of Figure 5.

In the third modified example, if the crystal optical axis of the quartz crystal prism 20a is set so as to make an angle of 45° with respect to the plane of polarization of the incoming P-polarized light, the P-polarized light that is incident on the quartz prism 20a is converted to light of a non-polarized condition and the mask M is thus illuminated in a non-polarized condition through the silica glass prism 20b. However, if the crystal optical axis of the quartz crystal prism 20a is set so as to make an angle of 0° or 90° with respect to the plane of polarization of the incoming P-polarized light, the P-polarized light is transmitted unchanged i.e. there is no change in the plane of polarization of the P-polarized light that is incident on the quartz crystal prism 20a and the mask M is thus illuminated in a P-polarized condition through the silica glass prism 20b.

As described above, in the third modified example of Figure 7, by suitably rotating the quartz crystal prism 20a about the optical axis AX, the polarization condition of the light that illuminates the mask M can be changed over between a linearly polarized condition and a non-polarized condition. It should be noted that, in the third modified example of Figure 7, even though the depolarizer 20 is constructed so as to be freely rotatable about the optical axis AX and is constructed so as to be freely inserted or withdrawn with respect to the illumination optical path, the same optical beneficial effect could be obtained by setting such that the mask M is illuminated in a P-polarized condition by withdrawal of the depolarizer 20 from the illumination optical path.

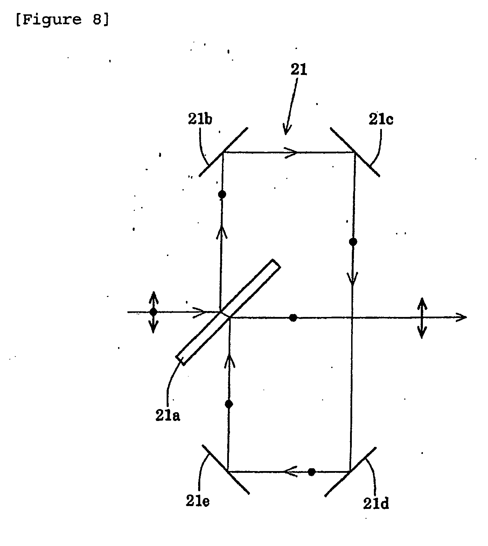

Figure 8 is a view showing diagrammatically the construction of a depolarizer according to a modified example. Although, in the embodiment described above and in the first modified example to the third modified example, a construction was adopted in which a depolarizer 20 and quartz crystal prism 20a were provided, as shown in the modified example of Figure 8, it would also be possible to construct a depolarizer 21 using a polarizing beam splitter 21a and reflection system (21b to 21e). Referring to Figure 8, a depolarizer 21 comprises a polarizing beam splitter 21a arranged in the illumination optical path. Of the light that is incident on the polarizing beam splitter 21a, the P-polarized light (its direction of polarization is indicated by two arrows in the Figure) is transmitted through the polarizing beam splitter 21a.

S-polarized light (whose direction of polarization is indicated by dots in the Figure) is reflected by the polarizing beam splitter 21a and is then reflected four times in a plane parallel to the plane of Figure 8 by the action of the reflecting system constituted by the four reflecting mirrors 21b to 21e, before being returned to the polarizing beam splitter 21a. This reflecting system (21b to 21e) is constructed such that the optical path of the P-polarized light that is transmitted through the polarizing beam splitter 21a and the optical path of the S-polarized light that is finally reflected by the polarizing beam splitter 21a substantially coincide. In this way, the P-polarized light that has been transmitted through the polarizing beam splitter 21a and the S-polarized light that is finally reflected by the polarizing beam splitter 21a are emitted from the depolarizer 21 along substantially the same optical path. That is, the S-polarized light is delayed by an amount corresponding to the optical path of the reflecting system (21b to 21e), compared with the P-polarized light.

The depolarizer 21 constituted by the polarizing beam splitter 21a and reflecting system (21b to 21e) has a basically equivalent optical action to that of the depolarizer 20 constituted by the quartz crystal prism 20a and silica glass prism 20b. Consequently, the depolarizer 20 of the embodiment and the first modified example to the third modified example can be replaced by a depolarizer 21 according to the modified example of Figure 8. That is, if the depolarizer 21 is employed in the embodiment of Figure 4, the polarizing beam splitter 21a and reflecting system (21b to 21e) are constructed so as to be capable of being inserted or withdrawn in unitary fashion with respect to the illumination optical path.

Also, if the depolarizer 21 is employed in the first modified example of Figure 5 or the third modified example of Figure 7, the polarizing beam splitter 21a and reflecting system (21b to 21e) are constructed so as to be freely rotatable in unitary fashion about the optical axis AX. In addition, if the depolarizer 21 is employed in the second modified example of Figure 6, the polarizing beam splitter 21a and the reflecting system (21b to 21e) are located in a fixed position in the illumination optical path.

In the depolarizer 21 according to the modified example of Figure 8, by setting the optical path length of the reflecting system (21b to 21e) substantially larger than the coherence length of the illuminating light (exposure light), reduction of the coherence of the laser light that illuminates the mask M, and hence reduction in the contrast of the speckle on the wafer W can be achieved. For detailed constructions and modified examples of various types of depolarizers comprising a polarizing beam splitter and a reflecting system that can be applied to the present invention, the reader is referred to for example Laid-open Japanese Patent Application No. H11-174365, Laid-open Japanese Patent Application No. H11-312631, or Laid-open Japanese Patent Application No. 2000-223396.

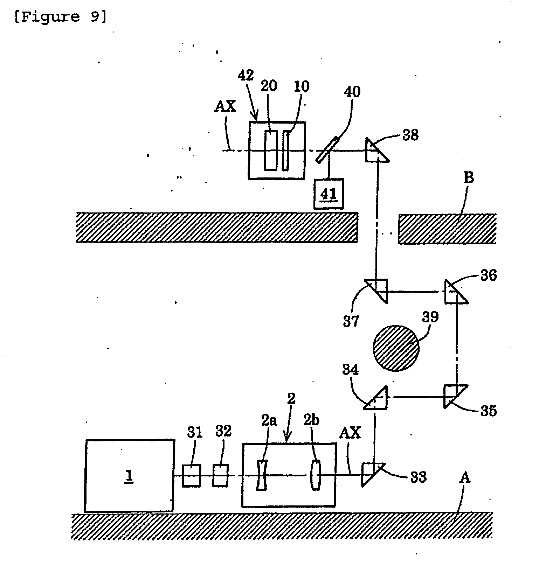

Figure 9 is a view showing diagrammatically the internal construction of a beam matching unit arranged between the light source and polarization condition changeover means in Figure 1. In the beam matching unit BMU shown in Figure 9, a parallel beam that is supplied from a laser light source 1 (such as for example a KrF excimer laser light source or ArF excimer laser light source) is input to the beam expander 2 after passing through a pair of deflecting prisms 31 and parallel planar plate 32. The laser light source 1 is arranged on for example lower-floor floor boards A.

At least one of the pair of deflecting prisms 31 is arranged to be capable of rotation about the optical axis AX. Consequently, the angle of the parallel beam with respect to the optical axis AX can be adjusted by rotating the pair of deflecting prisms 31 relatively about the optical axis AX. Specifically, the pair of deflecting prisms 31 constitute beam angle adjustment means for adjusting the angle of the parallel beam supplied from the laser light source 1 with respect to the optical axis AX. Also, the parallel planar plate 32 is constructed so as to be capable of rotation about two orthogonal axes in the plane perpendicular to the optical axis AX.

Consequently, the parallel beam can be displaced in parallel with the optical axis AX by tilting with respect to the optical axis AX by rotating the parallel planar plate 32 about these axes. That is, the parallel planar plate 32 constitutes beam parallel displacement means for displacing the parallel beam supplied from the laser light source 1 with respect to the optical axis AX. In this way, the parallel beam from the laser light source 1, after it has passed through the pair of deflecting prisms 31 and parallel planar plate 32, is magnified and shaped to a parallel beam having a prescribed cross-sectional shape by passing through the beam expander 2, before being input to a first right-angled prism 33.

The parallel beam that is deflected in the perpendicular direction by the first right-angled prism 33 constituting an internal-face reflecting mirror is successively reflected by a second right-angled prism 34 to fifth right-angled prism 37 likewise constituting internal-face reflecting mirrors, before passing through an aperture of the upper-floor floor boards B and being input to a sixth right-angled prism 38. As shown in Figure 9, the second right-angled prism 34 to fifth right-angled prism 37 are arranged such that the parallel beam that is deflected in the vertical direction by the first right-angled prism 33 and is directed towards the sixth right-angled prism 38 bypasses for example the piping for supply of pure water and the piping 39 for ventilation.

The beam that is deflected in the horizontal direction by the sixth right-angled prism 38 constituting an internal reflecting mirror is input to a half mirror 40. The beam that is reflected by the half mirror 40 is directed onto a positional displacement and tilting detection system 41. On the other hand, the beam that has passed through the half mirror 40 is directed onto a polarization condition changeover means 42 comprising a 1/2 wavelength plate 10 and depolarizer 20. The positional displacement and tilting detection system 41 detects positional displacement and tilting of the parallel beam that is input to the polarization condition changeover means 42 (and hence is input to the optical diffraction element 4 constituting an optical integrator) with respect to the optical axis AX.

However, when for example an ArF excimer laser light source is employed as the laser light source 1, typically, the required durability is secured by using fluorite for the optically transparent member that is subjected to illumination with light of high energy density. Recently, the present inventors discovered that fluorite has the property of varying the polarization condition of emitted light when subjected to illumination by laser light. In particular, the variation in polarization condition is marked when subjected to illumination with laser light of high output in the vacuum ultraviolet region, and the amount of this variation is different depending on the crystal orientation of the fluorite. Specifically, regarding the variation in polarization condition produced as a result of being subjected to illumination with laser light, this shows the property that the polarization condition of the light passing through the fluorite gradually varies during the course of a few tens of seconds from the commencement of illumination by laser light, and the polarization condition of the emitted light then settles down to a steady condition.

Also, the change in polarization condition produced by fluorite is, roughly speaking, recovered in a few tens of seconds from the cessation of the illumination by laser light. Consequently, if laser illumination and cessation of illumination of fluorite are repeated, variation in the polarization condition of the light that has passed through the fluorite is produced every time laser illumination is commenced. If incoming linearly polarized light through an optically transparent member formed by fluorite is changed to elliptically polarized light, the quartz crystal prism 20a in the polarization condition changeover means described above functions as a depolarizing element. Also, when performing control of the amount of light using a sensor in the exposure device, it is difficult to perform accurate control of the amount of light, since variation of the polarization condition changes the ratio of the polarization components of the light actually incident on the sensor.

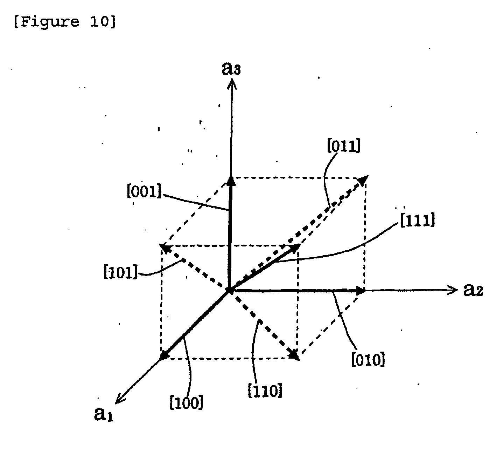

Figure 10 is a view given in explanation of the crystal orientation of fluorite. Referring to Figure 10, the crystal orientation of fluorite is specified using the crystal axes $a_1 a_2 a_3$ of the cubic system. Specifically, the crystal orientation [100] is specified along the crystallographic axis $+a_1$, the crystal orientation [010] is specified along the crystallographic axis $+a_2$, and the crystal orientation [001] is specified along the crystallographic axis $+a_3$, respectively. Also, the crystal orientation [101] is specified in the direction making an angle of 45° with the crystal orientation [100] and crystal orientation [001] in the $a_1 a_3$ plane; the crystal orientation [110] is specified in the direction making an angle of 45° with the crystal orientation [100] and crystal orientation [010] in the $a_1 a_2$ plane; and the crystal orientation [011] is specified in the direction making an angle of 45° with the crystal orientation [010] and crystal orientation [001] in the $a_2 a_3$ plane, respectively. In addition, the crystal orientation [111] is specified in a direction making equal acute angles with respect to the crystallographic axis $+a_1$, crystallographic axis $+a_2$ and crystallographic axis $+a_3$. Figure 10 shows only the crystal orientations in the space defined by the crystallographic axes $+a_1$, crystallographic axis $+a_2$ and crystallographic axis $+a$: the crystal orientations in the other spaces are specified in the same way.

It should be noted that, in the specification of the present application, "crystal orientations that are equivalents in terms of crystal structure with a given crystal orientation" means crystal orientations obtained by interchanging the order of indices of the crystal orientation in question or crystal orientations obtained by inverting these symbols in respect of at least some of these indices, with respect to a crystal structure with a given crystal orientation. For example, if the given crystal orientation is [uvw], then the crystal orientations [uwv], [vuw], [vwu], [wuv], [wvu], [-uvw], [-uwv], [-vuw], [-vwu], [-wuv], [-wvu], [u-vw], [u-wv], [v-uw], [v-wu], [w-uv], [w-vu], [uv-w], [uw-v], [vu-w], [vw-u], [wu-v], [wv-u], [-u-vw], [-u-wv], [-uv-w], [-uw-v], [-v-uw], [-v-wu], [-vu-w], [-vw-u], [-w-uv], [-w-vu], [-wu-v], [-wv-u], [u-v-w], [u-w-v], [v-u-w], [v-w-u], [w-u-v], [w-v-u], [-u-v-w], [-u-w-v], [-v-u-w], [-v-w-u], [-w-u-v], and [-w-v-u] are crystal orientations that are equivalents in terms of crystal structure. Also, in the present specification, the crystal orientation [uvw] and crystal orientations that are equivalents in terms of crystal structure therewith are denoted as crystallographic orientations < uvw >. Also, the crystal orientation [uvw] and the planes that are orthogonal to crystal orientations that are equivalent in terms of crystal structure therewith i.e. the crystal planes (uvw) and crystal planes that are equivalent in terms of crystal structure therewith are denoted as crystal planes {uvw}.

As a result of various experiments and investigations, the present inventors discovered that the variation of polarization condition produced by fluorite is actually caused by variation in birefringence of the fluorite itself. Also, although there are individual differences in the amount of variation of birefringence in fluorite, in substantially all the fluorite crystals that can currently be procured, it has been found that this phenomenon of variation of birefringence is unavoidable and hence the phenomenon of variation of polarization condition is unavoidable. Accordingly, based on the above discovery, in the present invention, two techniques are proposed for suppressing to the utmost variation in polarization condition of linearly polarized light that is incident on fluorite, since it is substantially impossible to eliminate the variation of birefringence from the fluorite itself.

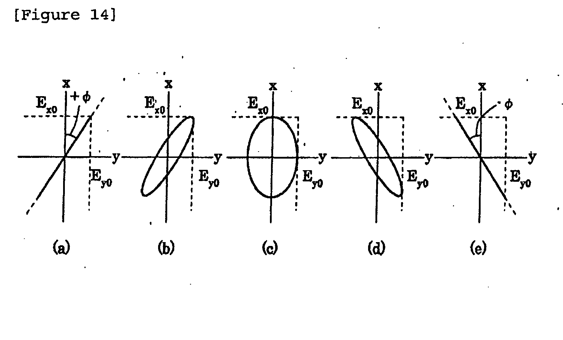

Typically, in incident light consisting of linearly polarized light, a phase difference between the fast axis component and slow axis component of the incoming light is produced by passage through a medium having birefringence, causing the light to change from linearly polarized light to elliptically polarized light. Figure 14 is a view showing how incoming linearly polarized light changes its polarization condition during passage through a medium having birefringence. In Figure 14, the x direction of the medium is taken as the fast axis direction and the y direction is taken as the slow axis direction and the case is considered of incidence such that the direction of oscillation of the electrical field of the incoming linearly polarized light is tilted by an angle $\phi$ from the x-axis to the y-axis direction (see Figure 14(a)).

If the x component and the y component of the amplitude of the electrical field are respectively designated as $Ex_0$ and $Ey_0$, the x component Ex and the y component Ey of the electrical field are respectively expressed by the following expression (1) and expression (2).

$$Ex = Ex_0 \cdot \cos\{\omega \cdot t - (2\pi/\lambda) \cdot (nx \cdot d)\} \qquad (1)$$

$$Ey = Ey_0 \cdot \cos\{\omega \cdot t - (2\pi/\lambda) \cdot (ny \cdot d)\} \qquad (2)$$

In expression (1) and (2), $\omega$ is the oscillation frequency of the light, t is the time, $\lambda$ is the wavelength of the light, nx is the refractive index of the medium in the fast-axis direction, ny is the refractive index of the medium in the slow-axis direction, and d is the optical path length in the medium. And since there is a difference between the refractive index nx of the fast-axis component and the refractive index ny of the slow-axis component in the medium, the phase difference between the fast-axis component and slow-axis component gradually increases as the light travels through the medium. In Figure 14, (b) corresponds to the polarization condition when the phase difference is 0 to $\pi/2$, (c) corresponds to the polarization condition when the phase difference is $\pi/2$, (d) corresponds to the polarization condition when the phase difference is $\pi/2$ to $\pi$ and (e) corresponds to the polarization condition when the phase difference is $\pi$, respectively. Thus, when linearly polarized light is directed onto a medium such as fluorite, the polarization condition of the emitted light can pass through elliptical polarization to become circular polarization or can pass through circular polarization to again become linear polarization.

Referring now to Figure 14, if the angle $\phi$ of the direction of oscillation of the electrical field of the incoming linearly polarized light is set to $\phi=0$ or $\phi=\pi/2$ i.e. if the direction of oscillation of the electrical field of the incoming linearly polarized light is set so as to be substantially coincident or substantially orthogonal with respect to the fast-axis direction relating to birefringent variation of the medium (for example an optically transparent member made of fluorite) the incoming linearly polarized light will have only one or other component of the fast-axis component and slow-axis component. As a result, no phase difference will be generated between the fast-axis component and slow-axis component and the incoming linearly polarized light will be emitted maintained in the same condition as linearly polarized light irrespective of variations of birefringence.

That is, in a first technique according to the present invention, in an optical system including an optically transparent member formed by a crystalline material such as for example fluorite, the fast-axis direction in regard to birefringent variation of the transparent member when subjected to optical illumination is ascertained. Variation of the polarization condition of the linearly polarized light incident on the optically transparent member can then be suppressed to the utmost by suppressing to the minimum the effect of birefringence variation on polarization condition variation by setting the fast-axis direction in regard to birefringent variation of the optically transparent member so as to substantially coincide with or be orthogonal to the direction of oscillation of the electrical field of the incoming linearly polarized light to the optically transparent member.

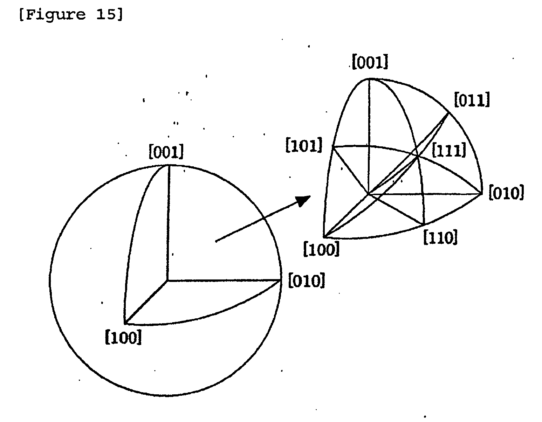

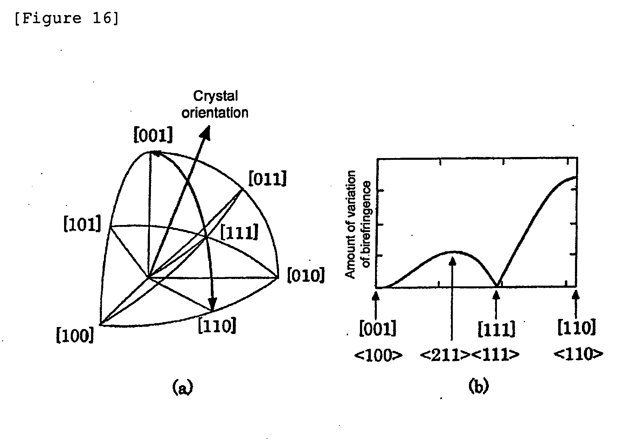

The present inventors also found from an examination of measurement results and stress birefringence (in an analysis using tensors, calculation assuming that stress components perpendicular to the optical axis are symmetrical) that dependence of crystal orientation must be taken into account in variation of birefringence. The crystal orientation dependence of birefringence is described below. Figure 15 is a view corresponding to Figure 10 and is a view in which the crystal orientation of fluorite is described using another method of representation. Figure 16 is a view showing diagrammatically the change of amount of birefringent variation in fluorite when the crystal orientation is varied between [001] and [110] and ArF excimer laser light is incident thereon along this crystal orientation.

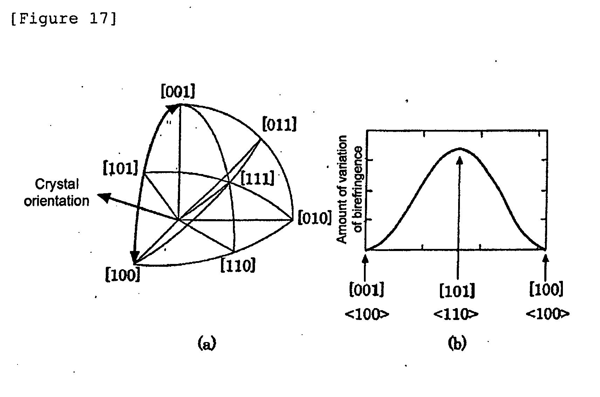

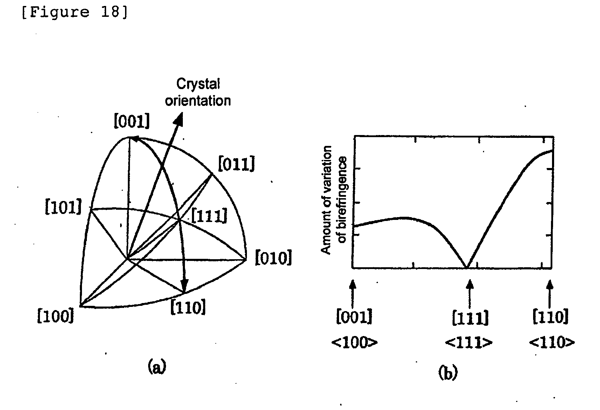

Also, Figure 17 is a view showing diagrammatically the change in amount of birefringent variation in fluorite when the crystal orientation is varied between [001] and [100] and ArF excimer laser light is incident thereon along this crystal orientation. Also, Figure 18 is a view corresponding to Figure 16 and is a view showing diagrammatically the change in amount of birefringent variation in fluorite when the energy density of the incoming light is extremely high. In Figure 16(b), Figure 17(b) and Figure 18(b), the horizontal axis indicates the crystal orientation at which the ArF excimer laser light is incident and the vertical axis indicates the amount of birefringent variation, respectively.

Referring to Figure 16, when the crystal orientation is varied from [001] through [111] to [110], it can be seen that the amount of birefringent variation when light is incident in the direction of the crystal orientation [001] and crystal orientation [111] is extremely small, and the amount of birefringent variation when light is incident in the direction of the crystal orientation [110] is a maximum. Specifically, it can be seen that the amount of birefringent variation when light is incident in the direction of the crystal orientation < 100 > and crystal orientation < 111 > is extremely small and the amount of birefringent variation when light is incident in the direction of the crystal orientation <110> is a maximum.

Referring to Figure 17, when the crystal orientation is varied from [001] through [101] to [100], it can be seen that the amount of birefringent variation when light is incident in the direction of the crystal orientation [001] and crystal orientation [100] is extremely small, and the amount of birefringent variation when light is incident in the direction of the crystal orientation [101] is a maximum. Specifically, it can be seen that the amount of birefringent variation when light is incident in the direction of the crystal orientation < 100 > is extremely small and the amount of birefringent variation when light is incident in the direction of the crystal orientation < 110 > is a maximum.

Referring to Figure 18, when the crystal orientation is varied from [001] through [111] to [110], it can be seen that the amount of birefringent variation when light is incident in the direction of the crystal orientation [111] is extremely small, the amount of birefringent variation when light is incident in the direction of the crystal orientation [001] is somewhat larger, and the amount of birefringent variation is a maximum when the light is incident in the direction of the crystal orientation [110]. Specifically, it can be seen that the amount of birefringent variation when light is incident in the direction of the crystal orientation < 111 > is extremely small, the amount of birefringent variation when light is incident in the direction of the crystal orientation < 100 > is somewhat larger, and the amount of birefringent variation is a maximum when the light is incident in the direction of the crystal orientation < 110 >.

As described above, referring to Figure 16 and Figure 17, in a fluorite crystal, it can be seen that, when light is incident in the direction of the crystal orientation < 110 >, the amount of birefringent variation is a maximum and when light is incident in the direction of the crystal orientation < 100 > and crystal orientation < 111 >, practically no birefringent variation is found. However, referring to Figure 18, it can be seen that a certain amount of birefringent variation appears, even if light is incident in the direction of the crystal orientation < 100 >, if the energy density of the incident light is extremely high or if large anisotropy is present in the illuminated area of the fluorite (due to large internal stress due to absorption of light by the fluorite being generated or input of light flux having a rotationally asymmetric cross section) etc.

Accordingly, in a second technique according to the present invention, in illumination optical equipment that illuminates a surface to be illuminated with light through an optically transparent member formed of crystalline material of the cubic system such as for example fluorite, the direction of propagation of the light in this optically transparent member is set so as to be closer to the crystal orientation < 111 > or crystal orientation < 100 > than to the crystal orientation < 110 >. As a result, generation of birefringent variation in this optical transparent member can be suppressed to a low level and hence variation of the polarization condition of linearly polarized light incident on this optically transparent member can be suppressed to the utmost. It should be noted that the beneficial effect of the present invention could be exhibited to an even greater degree by combining the first technique and the second technique.

In this embodiment, in an optically transparent member that is formed using fluorite arranged in the optical path between the laser light source 1 and polarization condition changeover means 42, the direction of propagation of the light is set so as to be closer to the crystal orientation < 111 > or crystal orientation < 100 > than to the crystal orientation < 110 >. Specifically, if an optical member that is fixedly located in position in the optical path, such as lens components (2a, 2b) constituting the beam expander 2, is formed using fluorite, the optical axis of this optical member is set so as to substantially coincide with the crystal orientation < 111 > or crystal orientation < 100 >.

In this case, since the laser light is transmitted substantially along the crystal orientation < 111 > or crystal orientation < 100 >, there is substantially no change in the polarization condition of the linearly polarized light transmitted through the lens components (2a, 2b). Likewise, also in the case where a pair of deflecting prisms 31 are formed of fluorite, by setting the optical axes so as to substantially coincide with the crystal orientation < 111 > or crystal orientation < 100 >, it is possible to substantially avoid change in the polarization condition of the transmitted linearly polarized light.

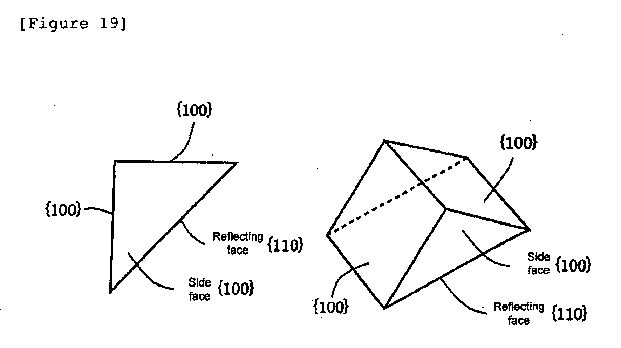

Also, if the right-angled prisms 33 to 38 constituting internal-face reflecting mirrors are formed of fluorite, as shown in Figure 19, the incident faces and emission faces of the right-angled prisms 33 to 38 are set so as to substantially coincide with the crystallographic plane {100} and the reflecting faces of the right-angled prisms 33 to 38 are set so as to substantially coincide with the crystallographic plane {110}. In this case, the side faces (strictly speaking, the planes defined by the optical axis of the incident face and the optical axis of the emission face) of the right-angled prisms 33 to 38 substantially coincide with the crystallographic plane {100}. In the construction of Figure 19, the laser light is transmitted substantially along the crystal orientation < 100 >, so the polarization condition of the linearly polarized light that is transmitted through the right-angled prisms 33 to 38 is substantially unchanged.

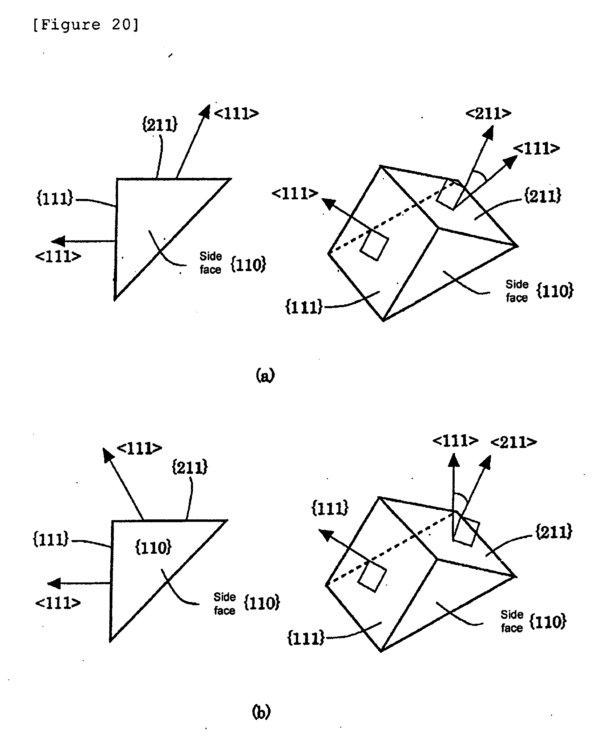

Also, as shown in Figure 20, one face of the incident face and emission face of the right-angled prisms is set such that it substantially coincides with the crystallographic plane {111} and the other face is set so that it substantially coincides with the crystallographic plane {211}. In this case, the side faces (strictly speaking, the planes defined by the optical axis of the incident face and the optical axis of the emission face) of the right-angled prisms substantially coincide with the crystallographic plane {110}. Also, since the optical axis (crystal orientation < 211 >) of the plane that substantially coincides with the crystallographic plane {211} is somewhat close to the crystal orientation < 111 >, change in the polarization condition of the linearly polarized light transmitted through the right-angled prism can be suppressed to a very considerable degree.

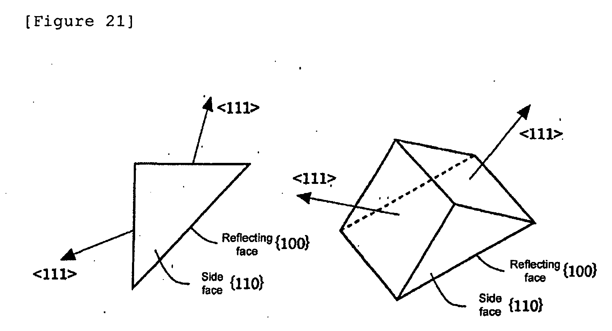

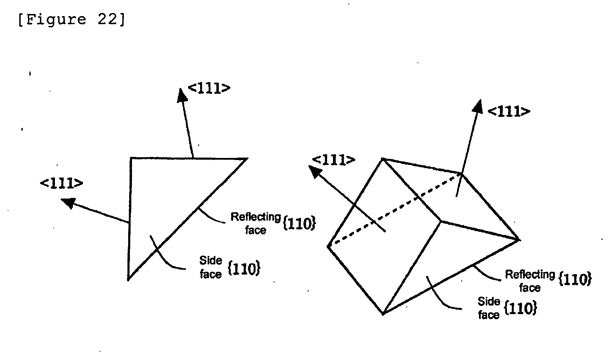

Also, as shown in Figure 21, the reflecting faces of the right-angled prisms can be set so as to substantially coincide with the crystallographic plane {100} and the side faces of the right-angled prisms (strictly speaking, the plane defined by the optical axis of the incident face and the optical axis of the emission face) can be set so as to substantially coincide with the crystallographic plane {110}. Also, as shown in Figure 22, the reflecting faces of the right-angled prisms and the side faces of the right-angled prisms (strictly speaking, the plane defined by the optical axis of the incident face and the optical axis of the emission face) can be set so as to substantially coincide with the crystallographic plane {110}. In these cases, the optical axis of the incident face and the optical axis of emission face of the right-angled prism are to some extent close to the crystal orientation < 111 >, so change in the polarization condition of the linearly polarized light transmitted through the right-angled prism can be suppressed to a very considerable degree.

It should be noted that, with reference to Figure 19 to Figure 22, although the description was given relating to a right-angled prism, in the case of an ordinary prism also, it is desirable to set the incident plane and emission plane thereof so as to substantially coincide with the crystallographic plane {100}, or to set it such that the incident plane and emission plane substantially coincide with the crystallographic plane {111}. Also, it is desirable to effect setting such that one plane of the incident plane and emission plane of the prism substantially coincides with the crystallographic plane {111}, and to effect setting such that the other plane substantially coincides with the crystallographic plane {100} or the crystallographic plane {211}.

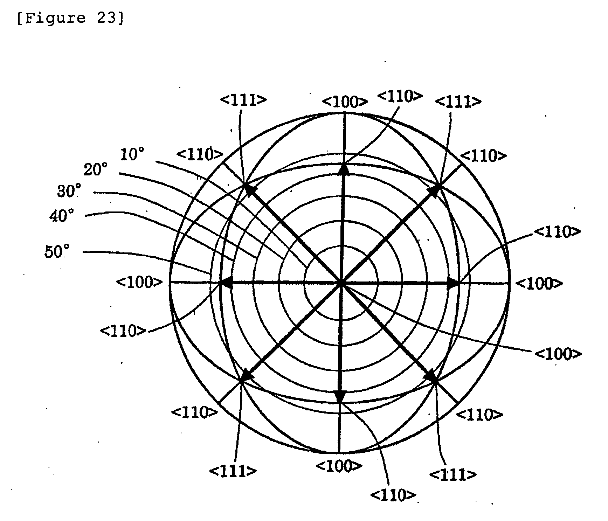

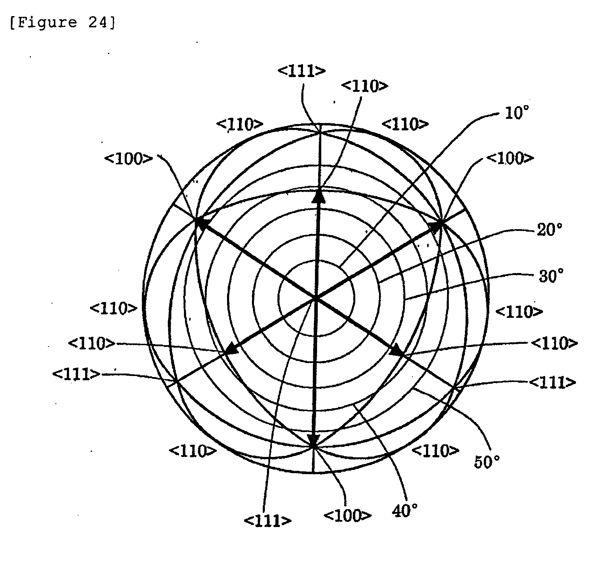

Also, if the parallel planar plate 32 constituting the beam parallel displacement means whereby a ray that is incident along the optical axis AX is displaced in parallel fashion and that is provided in the optical path in tiltable fashion with respect to the optical axis AX is formed of fluorite, the optical axis of the parallel planar plate 32 is set so as to substantially coincide with the crystal orientation < 100 >. This is because the crystal orientation < 100 > and the crystal orientation < 110 > make an angle of 45°, whereas the crystal orientation < 111 > and the crystal orientation < 110 > make an angle of about 35°. This will be clear by referring to Figure 23, which describes the arrangement of the crystal orientations seen from the direction of the crystal orientation < 100 > and Figure 24, which describes the arrangement of the crystal orientations seen from the direction of the crystal orientation < 111 >.

When the optical axis of the parallel planar plate 32 is made to substantially coincide with the crystal orientation < 100 > i.e. when its optical plane is made to substantially coincide with the crystallographic plane {100}, as shown in Figure 23, whichever side the parallel planar plate 32 is tilted to, a direction of inclination (in Figure 23, the upper left/lower right or lower left/upper right direction) that approaches the crystal orientation < 111 > exists, at about 55° from the crystal orientation < 100 >. In this way, by making the optical axis of the parallel planar plate 32 substantially coincide with the crystal orientation < 100 > and tilting to both sides along the direction from the crystal orientation < 100 > towards the crystal orientation < 111 >, even if the parallel planar plate 32 is tilted to its maximum (for example about 30°) with respect to the optical axis AX, a condition in which the direction of propagation of the laser light transmitted through the interior is separated to some extent from the crystal orientation < 110 > can be secured. As a result, change in the polarization condition of linearly polarized light transmitted through the parallel planar plate 32 can be suppressed to an excellent degree, irrespective of its attitude.

In contrast, when the optical axis of the parallel planar plate 32 is made to substantially coincide with the crystal orientation < 111 > i.e. when its optical plane is made to substantially coincide with the crystallographic plane {111}, as shown in Figure 24, when tilting is performed to one side, the crystal orientation < 100 > is approached at about 55° from the crystal orientation < 111 >; whereas, when tilting is performed to the other side, the crystal orientation < 110 > is approached at about 35° from the crystal orientation < 111 >. In this case, if an arrangement is adopted whereby large tilting is effected to one side along the direction from the crystal orientation < 111 > towards the crystal orientation < 100 > (in Figure 24, direction from the middle towards the upper right, from the middle towards the upper left, or straight downwards from the middle), but no tilting at all (or only a little tilting) is effected to the other side along the direction from the crystal orientation < 111 > towards the crystal orientation < 110 > (in Figure 24, direction from the middle towards the lower left, from the middle towards the lower right, or straight upwards from the middle), a condition can be secured in which the direction of propagation of the laser light passing through the interior during tilting is separated to some degree from the crystal orientation < 110 >. As a result, change in the polarization condition of linearly polarized light transmitted through the parallel planar plate 32 can be suppressed to an excellent degree, irrespective of its attitude.

It should be noted that, with the beam parallel displacement means, in order to effect parallel displacement of a light ray on two axes, typically there are provided a first parallel planar plate capable of being tilted about a first axis and a second parallel planar plate capable of being tilted about a second axis substantially orthogonal to the first axis.

In this case, preferably the second technique according to the present invention (and, if necessary, the first technique also) is applied in respect of the respective parallel planar plates.

It should be noted that, in the above description, the direction of propagation of the light was set so as to be closer to the crystal orientation < 111 > or the crystal orientation < 100 > than the crystal orientation < 110 >, in order to avoid change in polarization condition of linearly polarized light transmitted through the optically transparent member arranged in the optical path between the laser light source 1 and the polarization condition changeover means 42. However, there is no restriction to this and it is even more preferable to avoid change in the polarization condition of linearly polarized light caused in fluorite over the entire illumination optical path by performing setting in the same way in respect of optically transparent members arranged in the optical path between the polarization condition changeover means 42 and the mask M (and hence the wafer W) constituting the illuminated surface.

Also, in the above description, in order to avoid change in the polarization condition of linearly polarized light transmitted through an optically transparent member formed of fluorite, the direction of propagation of the light was set so as to be closer to the crystal orientation < 111 > or crystal orientation < 100 > than the crystal orientation < 110 >. However, there is no restriction to fluorite, and it is possible to avoid change in the polarization condition of linearly polarized light created in such a crystalline material by performing setting in the same way in respect of an optically transparent member formed by a crystalline material of the cubic system, such as for example calcium fluoride, barium fluoride, or magnesium fluoride.

Also, in the above description, in order to avoid change in plane of polarization of linearly polarized light transmitted through an optically transparent member formed by a crystalline material of cubic system such as fluorite, setting of the crystal orientation of this crystalline material was performed. Instead of this technique, or in addition to this technique, an optically transparent member formed by a crystalline material of the cubic system could be held kinematically using for example a technique as disclosed in US Patent publication US 2002/0163741A (or WO 02/16993). In this way, even in cases where this optically transparent member expands (contracts) due to heat generated when light of high energy density passes through the optically transparent member formed of crystalline material of cubic system such as fluorite, generation of stress birefringence in this optically transparent member can be suppressed, and change in the plane of polarization of linearly polarized light transmitted through this optically transparent member can thus also be suppressed.

In the beam matching unit BMU shown in Figure 9, a plurality (six in the case of the example shown in Figure 9) of right-angled prisms 33 to 38 are provided. Typically, whether the laser light beam is a KrF excimer laser light source or is an ArF excimer laser light source, when linearly polarized light is directed onto a right-angled prism constituting an internal-face reflection mirror, if the plane of polarization of the incoming linearly polarized light does not coincide with the P polarization plane or S polarization plane, the linearly polarized light is changed to elliptically polarized light by total reflection in the right-angled prism. In the case of the polarization condition changeover means 42 of this embodiment, it is assumed that linearly polarized light is input: the required effect cannot be achieved if elliptically polarized light is input.

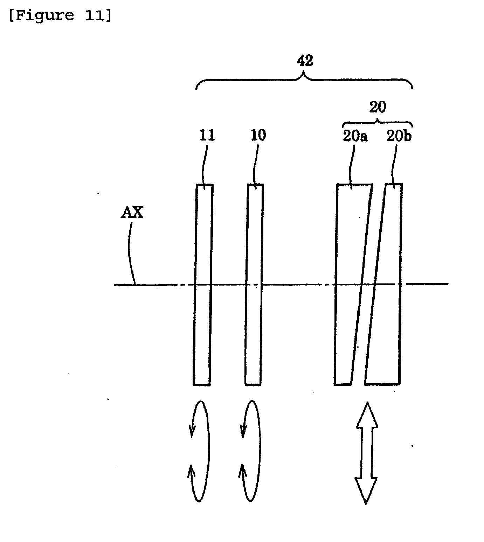

Accordingly, in this embodiment, as shown in Figure 11, preferably a 1/4 wavelength plate 11 arranged for example such that its crystal optical axis can be freely rotated about the optical axis AX and constituting a second phase member for converting incoming elliptically polarized light to linearly polarized light is additionally provided on the light source side (left side in the Figure) of the 1/2 wavelength plate 10 in the polarization condition changeover means 42. In this case, even if for example elliptically polarized light produced by the right-angled prism is input to the polarization condition changeover means 42, by setting the crystal optical axis of the 1/4 wavelength plate 11 in accordance with the characteristics of this incoming elliptically polarized light, the proper action of the polarization condition changeover means 42 on input of linearly polarized light to the 1/2 wavelength plate 10 can be maintained. It should be noted that, although, in Figure 11, the 1/4 wavelength plate 11 was arranged on the light source side of the 1/2 wavelength plate 10, it would also be possible to arrange the 1/4 wavelength plate 11 on the mask side (right-hand side in the Figure) of the 1/2 wavelength plate 10.

In the above description, the means for avoiding change of polarization condition of linearly polarized light transmitted through an optically transparent member formed of fluorite and the means for maintaining the proper action of polarization condition changeover means even when elliptically polarized light produced for example by a right-angled prism is input thereto were applied to this embodiment relating to Figure 1 to Figure 4. However, there is no restriction to this, and it would be possible to apply these means in the same way to the modified examples relating to Figure 5 to Figure 8.

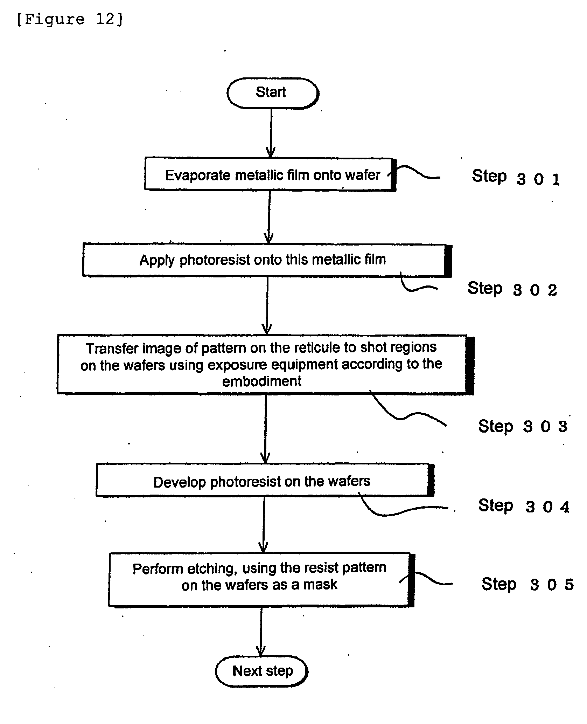

With such exposure equipment according to the embodiments described above, microdevices (semiconductor elements, image pickup elements, liquid crystal display elements or thin-film magnetic heads etc.) can be manufactured by illuminating (illumination step) a mask (reticule) by means of illumination optical equipment and exposing (exposure step) a pattern for transfer formed on a mask onto a photosensitive substrate using a projection optical system. Hereinbelow, an example of a technique for obtaining a semiconductor device, constituting an example of a microdevice, by forming a prescribed circuit pattern on for example a wafer constituting an example of a photosensitive substrate, using exposure equipment according to the embodiment described above, will be described with reference to the flowchart of Figure 12.

First of all, a metallic film is evaporated onto wafers of one lot in the step 301 of Figure 12. Next, in the step 302, photoresist is applied onto the metallic film on the wafers of this one lot. After this, in the step 303, the image of the pattern on a mask is successively transferred by exposure into the shot regions on the wafers of this one lot, using the projection optical system. After this, in step 304, development of the photoresist on the wafers in this one lot is performed; then, in step 305, etching is performed, using as a mask the resist pattern on the wafers of this one lot: a circuit pattern corresponding to the pattern on the mask is thereby formed in the shot regions of the wafers. After this, a device such as a semiconductor element is manufactured by performing for example formation of circuit patterns on further layers thereof. Semiconductor devices having very fine circuit patterns can be obtained with high throughput by the semiconductor device manufacturing method described above.

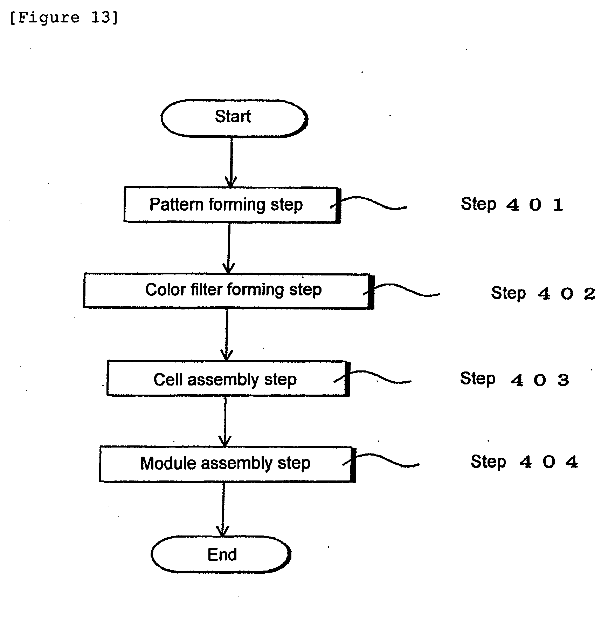

Also, in the exposure equipment according to the embodiments described above, a liquid crystal display element constituting an example of a microdevice can be obtained by forming a prescribed pattern (circuit pattern and electrode pattern etc.) on a plate (glass substrate). An example of the technique that is then employed is described below with reference to the flow chart of Figure 13. In Figure 13, in the pattern forming step 401, a so-called photolithographic step is executed in which the pattern of a mask is exposed and transferred onto a photosensitive substrate (for example a glass substrate coated with resist) using exposure equipment according to the embodiment described above. A prescribed pattern including for example a large number of electrodes is formed on the photosensitive substrate by this photolithographic step. Then, a prescribed pattern is formed on the exposed substrate by undergoing various steps such as a development step, etching step, and resist removal step, and the substrate is then transferred to the subsequent color filter forming step 402.

Next, in the color filter forming step 402, a color filter is formed in which a large number of sets of three dots corresponding to R (red), G (Green), and B (blue) are arranged in matrix fashion or sets of filters with three stripes: R, G and B are arranged in a plurality of horizontal scanning line directions. After this color filter forming step 402, a cell assembly step 403 is then executed. In the cell assembly step 403, liquid crystal panels (liquid crystal cells) are assembled using for example substrates having a prescribed pattern obtained by the pattern forming step 401 and color filters obtained by the color filter forming step 402.

In the cell assembly step 403, liquid crystal panels (liquid crystal cells) are manufactured for example by injecting liquid crystal between substrates having a prescribed pattern obtained in the pattern forming step 401 and color filters obtained by the color filter forming step 402. After this, in a module assembly step 404, various components such as electrical circuits for performing the display action of the liquid crystal panels (liquid crystal cells) that have thus been assembled and back lights are attached to complete the formation of the liquid crystal display element. With a method of manufacturing liquid crystal display elements as described above, liquid crystal display elements having an extremely fine circuit pattern can be obtained with high throughput.

It will be noted that, in the embodiments described above, light from a secondary light source was condensed by a condensing optical system 9 and used to illuminate a mask M in superimposed fashion. However, there is no restriction to this and it would also be possible to arrange an illuminated field of view stop (mask blind) and a relay optical system whereby an image of this mask blind is formed on the mask M in the optical path between the condensing optical system 9 and the mask M. In this case, the condensing optical system 9 condenses the light from the secondary light source and illuminates the mask blind in superimposed fashion and the relay optical system forms an image of the aperture (optically transparent portion) of the mask blind on the mask M.

Also, in the embodiments described above, the technique of filling the optical path between the projection optical system and the photosensitive substrate with a medium (typically a liquid) having a refractive index greater than 1.1 i.e. the so-called liquid immersion method may be applied. In this case, as a technique for filling the optical path between the projection optical system and the photosensitive substrate with a liquid, for example the technique of locally filling with liquid, as disclosed in International Laid-open Patent Application No. WO 99/49504, the technique of displacing a stage holding a substrate that is to be exposed in a liquid tank, as disclosed in Laid-open Japanese Patent Application No. H6-124873, or the technique of forming a liquid tank of a prescribed depth on a stage, and holding the substrate therein, as disclosed in Laid-open Japanese Patent Application No. H10-303114, may be employed.

It should be noted that preferably a liquid is employed that is transparent to the exposure light but is of as high refractive index as possible and that is stable with respect to the projection optical system and the photoresist that is applied to the substrate surface: for example, in the case where KrF excimer laser light or ArF excimer laser light is used as the exposure light, pure water or deionised water may be employed as the liquid. Also, in the case where $F_2$ laser light is employed as the exposure light, a fluorine-based liquid such as for example a fluorine-based oil or perfluoropolyether (PFPE) that is capable of transmitting $F_2$ laser light may be employed as the liquid.

Also, although, in the embodiments described above, KrF excimer laser light (wavelength: 248 nm) or ArF excimer laser light (wavelength: 193 nm) was employed as the exposure light, there is no restriction to this and the present invention may be applied to other suitable laser light sources such as for example an $F_2$ laser light source that supplies laser light of wavelength 157 nm, or light sources other than laser light sources, such as for example lamp light sources, that supply ultraviolet light such as for example i rays or g rays or h rays. In addition, although, in the embodiments described above, the present invention was described taking as an example projection optical equipment comprising illumination optical equipment, clearly the present invention could be applied to typical illumination optical equipment for illuminating surfaces to be illuminated other than masks.

Explanation of the reference symbols

1 laser light source
4 optical diffraction element (optical integrator)
5 afocal zoom lens
6, 60 to 63 optical diffraction elements
7 zoom lens
8 microlens array (fly-eye lens)
9 condenser optical system
10 phase member (1/2 wavelength plate)
20, 21 depolarizers
20a quartz crystal prism
20b silica glass prism
21a polarizing beam splitter
M mask
PL optical projection system
W wafer

**Claims**

1. An optical system including an optically transparent member formed of crystalline material, **characterized in that** the direction of the fast axis relating to variation of birefringence of said optically transparent member when subjected to optical illumination is set to be substantially coincident with or substantially orthogonal to the direction of oscillation of the electrical field of linearly polarized light incident on said optically transparent member.

2. Optical illumination equipment comprising an optical system according to claim 1, **characterized in that** the surface to be illuminated is illuminated with light through this optical system.

3. Optical illumination equipment including an optically transparent member formed of crystalline material of the cubic system, wherein a surface to be illuminated is illuminated with light through this optically transparent member, **characterized in that**:
   the direction of propagation of the light in said optically transparent member is set so as to be closer to the crystal orientation < 111 > or crystal orientation < 100 > than to crystal orientation < 110 >.

4. The optical illumination equipment according to claim 3, **characterized in that** said optically transparent member comprises an optical member that is fixedly located in position in the optical path and the optical axis of said optical member is set so as to substantially coincide with the crystal orientation < 111 > or crystal orientation < 100 >.

5. The optical illumination equipment according to claim 3, **characterized in that** said optically transparent member comprises a prism and the input face and output face of said prism are set so as to substantially coincide with the crystallographic plane {100}.

6. The optical illumination equipment according to claim 3, **characterized in that** said optically transparent member comprises a prism and the input face and output face of said prism are set so as to substantially coincide with the crystallographic plane {111}.

7. The optical illumination equipment according to claim 3, **characterized in that** said optically transparent member comprises a prism and one of the faces of the input face and output face of said prism is set to substantially coincide with the crystallographic plane {111} and the other face thereof is set to substantially coincide with the crystallographic plane {100} or the crystallographic plane {211}.

8. The optical illumination equipment according to claim 3, **characterized in that** said optically transparent member comprises a right-angled prism constituting an internal-face reflecting mirror and a reflecting face of said right-angled prism is set to substantially coincide with the crystallographic plane {100} and the plane defined by the optical axis of the input face of said right-angled prism and the optical axis of the output face of said right-angled prism is set so as to substantially coincide with the crystallographic plane {110}.

9. The optical illumination equipment according to claim 3, **characterized in that** said optically transparent member comprises a right-angled prism constituting an internal-face reflecting mirror and the reflecting face of said right-angled prism and the plane defined by the optical axis of the input face of said right-angled prism and the optical axis of the output face of said right-angled prism are set to substantially coincide with the crystallographic plane {110}.

10. The optical illumination equipment according to claim 3, **characterized in that** said optically transparent member comprises a parallel planar plate for parallel displacement of a light ray that is incident along said optical axis, provided in said optical path in a manner capable of being tilted with respect to the optical axis and **in that** the optical axis of said parallel planar plate is set so as to substantially coincide with the crystal orientation < 100 >.

11. The optical illumination equipment according to claim 10, **characterized in that** said parallel planar plate is capable of being tilted in a direction from crystal orientation < 100 > towards crystal orientation < 111 >.

12. The optical illumination equipment according to claim 3, **characterized in that** said optically transparent member comprises a parallel planar plate for parallel displacement of a ray incident along said optical axis, provided in said optical path in a manner capable of being tilted with respect to the optical axis and **in that** the optical axis of said parallel planar plate is set so as to substantially coincide with the crystal orientation < 111 >.

13. The optical illumination equipment according to claim 12, **characterized in that** said parallel planar plate is capable of being tilted from the crystal orientation < 111 > towards the crystal orientation < 100 >.

14. The optical illumination equipment according to any of claims 10 to 13, **characterized in that** said optically transparent member comprises a first parallel planar plate capable of being tilted about a first axis and a second parallel planar plate capable of being tilted about a second axis substantially orthogonal to said first axis.

15. The optical illumination equipment according to any of claims 3 to 14, **characterized in that** the direction of the fast axis relating to variation of birefringence of said optically transparent member when subjected to optical illumination is set so as to be substantially coincident with or substantially orthogonal to the direction of oscillation of the electrical field of the linearly polarized light that is incident on said optically transparent member.

16. The exposure equipment comprising optical illumination equipment according to any of claims 2 to 15, **characterized in that** the pattern of a mask arranged at said surface to be illuminated is exposed onto a photosensitive substrate.

17. An exposure method, **characterized in that** a mask is illuminated through optical illumination equipment according to any of claims 2 to 15 and **in that** a pattern formed on said illuminated mask is exposed onto a photosensitive substrate

[Figure 1]

[Figure 2]

(a)

(b)

[Figure 3]

(a)

(b)

[Figure 4]

[Figure 5]

EP 1 662 553 A1

[Figure 6]

25

[Figure 7]

[Figure 8]

[Figure 9]

[Figure 10]

EP 1 662 553 A1

[Figure 11]

30

[Figure 12]

```
                        ┌─────────┐
                        │  Start  │
                        └────┬────┘
                             │
                             ▼
        ┌────────────────────────────────────────┐
        │   Evaporate metallic film onto wafer    │      Step 3 0 1
        └────────────────────┬───────────────────┘
                             │
                             ▼
    ┌──────────────────────────────────────────────┐
    │      Apply photoresist onto this metallic film │      Step 3 0 2
    └────────────────────────┬─────────────────────┘
                             │
                             ▼
  ┌──────────────────────────────────────────────────┐
  │  Transfer image of pattern on the reticule to shot regions │
  │  on the wafers using exposure equipment according to the   │
  │                    embodiment                     │      Step 3 0 3
  └────────────────────────┬─────────────────────────┘
                             │
                             ▼
        ┌────────────────────────────────────────┐
        │      Develop photoresist on the wafers   │      Step 3 0 4
        └────────────────────┬───────────────────┘
                             │
                             ▼
      ┌──────────────────────────────────────────┐
      │   Perform etching, using the resist pattern │
      │         on the wafers as a mask           │      Step 3 0 5
      └────────────────────┬─────────────────────┘
                             │
                             ▼
                        ┌───────────┐
                        │ Next step │
                        └───────────┘
```

[Figure 13]

```
        ┌─────────┐
        │  Start  │
        └─────────┘
             │
             ▼
  ┌──────────────────────┐
  │ Pattern forming step │ ~~~~  Step 4 0 1
  └──────────────────────┘
             │
             ▼
  ┌──────────────────────────┐
  │ Color filter forming step│ ~~~~  Step 4 0 2
  └──────────────────────────┘
             │
             ▼
  ┌──────────────────────┐
  │  Cell assembly step  │ ~~~~  Step 4 0 3
  └──────────────────────┘
             │
             ▼
  ┌──────────────────────┐
  │ Module assembly step │ ~~~~  Step 4 0 4
  └──────────────────────┘
             │
             ▼
        ┌─────────┐
        │   End   │
        └─────────┘
```

[Figure 14]

(a)     (b)     (c)     (d)     (e)

[Figure 15]

[Figure 16]

(a)

(b)

[Figure 17]

Crystal
orientation

[001]
[011]
[101]
[111]
[010]
[100]
[110]

(a)

Amount of variation
of birefringence

[001]
<100>

[101]
<110>

[100]
<100>

(b)

[Figure 18]

Crystal orientation

[001]

[011]

[101]

[111]

[010]

[100]

[110]

(a)

Amount of variation of birefringence

[001]
<100>

[111]
<111>

[110]
<110>

(b)

[Figure 19]

[Figure 20]

(a)

(b)

[Figure 21]

[Figure 22]

[Figure 23]

[Figure 24]

<div align="center">

**INTERNATIONAL SEARCH REPORT**

</div>

| International application No. |
|---|
| PCT/JP2004/009128 |

| A. CLASSIFICATION OF SUBJECT MATTER |
|---|
| Int.Cl⁷  H01L21/027, G02B27/28, G02B19/00 |

According to International Patent Classification (IPC) or to both national classification and IPC

| B. FIELDS SEARCHED |
|---|
| Minimum documentation searched (classification system followed by classification symbols)<br>    Int.Cl⁷  H01L21/027, G02B27/28, G02B19/00 |

| Documentation searched other than minimum documentation to the extent that such documents are included in the fields searched |
|---|
| Jitsuyo Shinan Koho          1922–1996   Toroku Jitsuyo Shinan Koho    1994–2004<br>Kokai Jitsuyo Shinan Koho     1971–2004   Jitsuyo Shinan Toroku Koho     1996–2004 |

| Electronic data base consulted during the international search (name of data base and, where practicable, search terms used) |
|---|
|  |

### C. DOCUMENTS CONSIDERED TO BE RELEVANT

| Category* | Citation of document, with indication, where appropriate, of the relevant passages | Relevant to claim No. |
|---|---|---|
| X<br>Y | JP 5-109601 A  (Nikon Corp.),<br>30 April, 1993 (30.04.93),<br>Par. Nos. [0028] to [0030]; Fig. 2<br>(Family: none) | 1,2,16,17<br>15 |
| X<br>Y<br>A | JP 2003-43223 A  (Nikon Corp.),<br>13 February, 2003 (13.02.03),<br>Claims; Par. Nos. [0029] to [0039]; Fig. 4<br>(Family: none) | 3,4<br>5,6<br>7-9 |
| X<br>Y<br>A | JP 2003-161708 A  (Nikon Corp.),<br>06 June, 2003 (06.06.03),<br>Par. Nos. [0018], [0019], [0052], [0071]<br>& US 2003-112501 A1      & EP 1316848 A2 | 3,4<br>5,6<br>7-9 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    25 August, 2004 (25.08.04) | Date of mailing of the international search report<br>    05 October, 2004 (05.10.04) |
|---|---|
| Name and mailing address of the ISA/<br>    Japanese Patent Office | Authorized officer |
| Facsimile No. | Telephone No. |

Form PCT/ISA/210 (second sheet) (January 2004)

<div align="center">

**INTERNATIONAL SEARCH REPORT**

</div>

| | International application No. |
|---|---|
| | PCT/JP2004/009128 |

C (Continuation). DOCUMENTS CONSIDERED TO BE RELEVANT

| Category* | Citation of document, with indication, where appropriate, of the relevant passages | Relevant to claim No. |
|---|---|---|
| X | JP 2003-131002 A (Canon Inc.), 08 May, 2003 (08.05.03), | 3,4,10,12, 16,17 |
| Y | Claims; Par. Nos. [0003], [0027] to [0031], | 14 |
| A | [0056] & US 2003/000453 A1 & WO 03/003072 A2 | 11,13 |
| Y | JP 1-147516 A (Canon Inc.), 09 June, 1989 (09.06.89), Claims; examples (Family: none) | 14 |
| X | JP 2003-161882 A (Nikon Corp.), 06 June, 2003 (06.06.03), | 3,4 |
| Y | Claims 1, 3 & WO 03/46634 A1 | 15 |

Form PCT/ISA/210 (continuation of second sheet) (January 2004)

| **INTERNATIONAL SEARCH REPORT** | International application No. |
|---|---|
| | PCT/JP2004/009128 |

**Box No. II     Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III     Observations where unity of invention is lacking (Continuation of item 3 of first sheet)**

This International Searching Authority found multiple inventions in this international application, as follows:
    The constitution in claims 3, 4 that the optical axis of a light transmitting member is allowed to agree with a crystal orientation <111> or <100> has been found by our search to be clearly a conventionally known prior art as indicated by the international search.
    Consequently, the above constitution is not a special technical feature within the meaning of PCT Rule 13.2, second sentence.
    Therefore, there exists no technical feature common to respective claims 1, 2, 15 and claims 5-14.

1. ☒ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**          ☐ The additional search fees were accompanied by the applicant's protest.

          ☒ No protest accompanied the payment of additional search fees.

Form PCT/ISA/210 (continuation of first sheet (2)) (January 2004)